(19) Europäisches Patentamt
European Patent Office
Office européen des brevets

(11) **EP 3 516 456 B1**

(12) **EUROPÄISCHE PATENTSCHRIFT**

(45) Veröffentlichungstag und Bekanntmachung des Hinweises auf die Patenterteilung:
**30.11.2022 Patentblatt 2022/48**

(21) Anmeldenummer: **17758853.0**

(22) Anmeldetag: **24.08.2017**

(51) Internationale Patentklassifikation (IPC):
**G03F 7/20** $^{(2006.01)}$ **G03F 7/095** $^{(2006.01)}$

(52) Gemeinsame Patentklassifikation (CPC):
**G03F 7/095; G03F 7/70458; G03F 7/70466**

(86) Internationale Anmeldenummer:
**PCT/EP2017/071303**

(87) Internationale Veröffentlichungsnummer:
**WO 2018/054647 (29.03.2018 Gazette 2018/13)**

(54) **PROJEKTIONSBELICHTUNGSVERFAHREN UND PROJEKTIONSBELICHTUNGSANLAGE FÜR DIE MIKROLITHOGRAPHIE**

PROJECTION EXPOSURE METHOD AND PROJECTION EXPOSURE SYSTEM FOR MICROLITHOGRAPHY

PROCÉDÉ D'EXPOSITION PAR PROJECTION ET SYSTÈME D'EXPOSITION PAR PROJECTION POUR MICROLITHOGRAPHIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.09.2016 DE 102016217929**

(43) Veröffentlichungstag der Anmeldung:
**31.07.2019 Patentblatt 2019/31**

(73) Patentinhaber: **Carl Zeiss SMT GmbH**
**73447 Oberkochen (DE)**

(72) Erfinder: **PATRA, Michael**
**73447 Oberkochen (DE)**

(74) Vertreter: **Patentanwälte**
**Ruff, Wilhelm, Beier, Dauster & Partner mbB**
**Kronenstraße 30**
**70174 Stuttgart (DE)**

(56) Entgegenhaltungen:
CN-A- 105 334 699    US-A- 4 937 619
US-A1- 2004 029 034    US-A1- 2010 272 967

**Beschreibung**

ANWENDUNGSGEBIET UND STAND DER TECHNIK

Die Erfindung betrifft ein Projektionsbelichtungsverfahren zur Belichtung eines im Bereich einer Bildebene eines Projektionsobjektivs angeordneten Substrates mit mindestens einem Bild eines im Bereich einer Objektebene des Projektionsobjektivs angeordneten Musters einer Maske sowie eine zur Durchführung des Verfahrens geeignete Projektionsbelichtungsanlage.

Zur Herstellung von Halbleiterbauelementen und anderen fein strukturierten Bauteilen, wie z.B. strukturierten Komponenten für die Mikrosystemtechnik, werden heutzutage überwiegend mikrolithografische Projektionsbelichtungsverfahren eingesetzt. Hochintegrierte Halbleiterbauelemente weisen typischerweise eine Mehrzahl von Schichten (Layern) auf, von denen nur einige wenige Schichten sehr fein, z.B. auf der Skala einiger Dutzend Nanometer, strukturiert sind, während andere Schichten deutlich gröbere Strukturen besitzen. Erstere Schichten realisieren insbesondere die eigentliche Hauptfunktion des Halbleiterbauelements, wie z.B. Berechnungen und Speicherung von Daten, während letztere Schichten z.B. der Adressierung und Stromversorgung dienen. Strukturen mit relativ groben typischen Dimensionen gibt es auch im Bereich der Mikrosystemtechnik, wie z.B. bei mikroelektromechanischen Systemen (MEMS) oder bei mikrooptoelektromechanischen Systemen (MOEMS). Halbleiterbauelemente werden typischerweise aus einem Substrat eines Halbleiters hergestellt, während in der Mikrosystemtechnik auch andere Substratmaterialien, insbesondere Metalle und glasartige Stoffe, verwendet werden.

Bei der mikrolithographischen Projektionsbelichtung werden Masken (Retikel) verwendet, die das Muster einer abzubildenden Struktur tragen, z.B. ein Linienmuster einer Schicht (layer) eines Halbleiter-Bauelements. Eine Maske wird in eine Projektionsbelichtungsanlage zwischen einem Beleuchtungssystem und einem Projektionsobjektiv im Bereich der Objektebene des Projektionsobjektivs positioniert und mit einer vom Beleuchtungssystem bereitgestellten Beleuchtungsstrahlung beleuchtet. Die durch die Maske und das Muster veränderte Strahlung läuft als Projektionsstrahlung durch das Projektionsobjektiv, welches das Muster der Maske auf das zu belichtende Substrat abbildet. Bei dem Substrat kann es sich z.B. um einen Halbleiterwafer handeln. Das zu belichtende Substrat trägt an seiner zu strukturierenden Seite eine strahlungsempfindliche (d.h. photosensitive) Schicht aus Fotolackmaterial. Diese Schicht wird auch als Resistschicht bezeichnet.

Damit beim Belichtungsprozess ein möglichst vorlagengetreues Abbild des Musters auf das Substrat übertragen wird, sollte die strahlungsempfindliche Schicht an der Substratoberfläche während des Belichtungszeitintervalls im bildseitigen Fokusbereich des Projektionsobjektivs liegen. Insbesondere sollte die auf der Substratoberfläche angeordnete Schicht im Bereich der Schärfentiefe (depth of focus, DOF) des Projektionsobjektivs liegen.

Nach einer gängigen Definition gibt die Schärfentiefe den Abstand relativ zur Ebene besten Fokus an, bei dem die Intensität eines Punktbildes mindestens 80% der Intensität in der Ebene besten Fokus beträgt. Dies ist äquivalent zur Bedingung, dass sich der Durchmesser des Punktbildes maximal verdoppelt. Die Schärfentiefe beträgt die Hälfte der Rayleigh-Einheit RU, die als $RU = \lambda/NA^2$ definiert ist, wobei $\lambda$ die Arbeitswellenlänge der Projektionsbelichtungsanlage und NA die bildseitige numerische Apertur des Projektionsobjektivs ist; der Bereich, in welchem die Schärfentiefenbedingung erfüllt ist, besitzt dementsprechend eine Gesamtdicke gleich der Rayleigh-Einheit RU. Im Allgemeinen wird die Schärfentiefe geringer, je höher das Auflösungsvermögen des Projektionsobjektivs ist.

Eine weitere Verkleinerung der Strukturgrößen auf Computerchips wird technisch und physikalisch immer schwieriger. Die damit verbundenen Kosten machen eine weitere Verkleinerung der Strukturgrößen in manchen Fällen immer weniger attraktiv. Als Alternative zur besseren Ausnutzung der Waferfläche kann an Stelle dessen die dritte Dimension ausgenutzt werden, indem Strukturen nicht nur auf bzw. an der Oberfläche des Wafers, sondern in Tiefenrichtung in den Wafer hinein erzeugt werden.

Die dritte Dimension wurde z.B. bereits für die Herstellung von DRAM-Strukturen genutzt, bei denen die notwendigen Kondensatoren in die Tiefe geätzt werden (siehe z.B. US 2012/0049262 A1). Ein anderer Trend ist die dreidimensionale Stapelung von Flashspeicher-Strukturen (siehe z.B. US 8,445,447 B2). Da die aufgewachsenen Siliziumschichten amorph an Stelle von kristallin sind, können aus elektronischen Gründen nur relativ grobe Strukturen funktionsfähig erzeugt werden, weswegen die Verwendung von relativ kurzen Wellenlängen wie 193 nm oder gar 13 nm für derartige Lithographieprozesse in der Regel nicht notwendig ist.

Um tiefe Strukturen erzeugen zu können, müssen Löcher mit einem großen Aspektverhältnis zwischen Tiefe und Breite in das Substrat geätzt werden. Dies kann zum Beispiel durch einen trockenen Ätzprozess, wie z.B. mittels Ionenätzens, geschehen. Derartige Ätzverfahren greifen nicht nur das Substrat an, sondern auch den entwickelten und gehärteten Fotolack an. Die strahlungsempfindliche Schicht sollte daher eine nicht zu geringe Mindestdicke aufweisen.

Für die Belichtung relativ dicker Fotolackschichten ist im Bereich der 193 nm-Immersionslithographie die Verwendung des sogenannten "Focus Drilling" bekannt. Die dort verwendeten ArF-Laserquellen sind so schmalbandig, dass es nicht notwendig ist, die entsprechenden Projektionsobjektive chromatisch vollständig zu korrigieren. Die Wellenlängenabhängigkeit des Projektionsobjektives besteht vor allem in einer von der Wellenlänge der verwendeten Strahlung abhängigen (farbabhängigen) Fokuslage. Durch gezieltes Verstellen des Line-Narrowing-Moduls (LNM) eines ArF-Lasers kann die Bandbreite des Lasers künstlich vergrößert werden. Verschiedene Bestandteile des innerhalb der genutzten Bandbreite kontinuierlichen Spektrums erzeugen dann gleichzeitig verschiedene Fokuslagen. Es kommt damit zu einer effektiven Vergrößerung der Tiefe des innerhalb der Fotolackschicht durchbeleuchteten Bereichs. Diese Vergrößerung der effektiv nutzbaren Schärfentiefe führt allerdings zu einer Verschmierung und damit zu einer Kontrastverringerung, was am fertig strukturierten Substrat zu gröberen und/oder ungenauer definierbaren Strukturen führt.

Der Artikel: "Thick Photoresist Imaging Using A Three Wavelength Exposure Stepper" von B. Todd, W.W. Flack und S. White in: SPIE MEMS 1999 #3874 -40, Seiten 1 - 15 beschreibt die Tauglichkeit dreier ultradicker Fotolacke (Schichtdicken bei 50 $\mu$m oder 100 $\mu$m) für die Anwendung bei der Mikrostrukturierung mit großen Aspektverhältnissen unter Verwendung eines Wafersteppers mit einer Quecksilberdampflampe als Strahlungsquelle. Für die Abbildung wird ein katadioptrisches Projektionsobjektiv vom 1X Wynne-Dyson-Typ mit bildseitiger numerischer Apertur NA = 0.16 verwendet. Projektionsobjektive vom Wynne-Dyson-Typ erlauben eine breitbandige Belichtung ohne Einführung chromatischer Aberrationen. Zur Belichtung werden in einem breiten Spektralbereich von 350 nm bis 450 nm gleichzeitig die g-, h- und i-Linie des Quecksilbers genutzt (ghi-Stepper). Die Ergebnisse werden mit Ergebnissen anderer Versuche mit einem gh-Linien Stepper und einem i-Linien-Steppern höherer NA verglichen.

Eine andere Technologie zur Erzeugung von tief in ein Substrat reichenden Löchern mit großem Aspektverhältnis ist die Mehrfachstrukturierung unter Verwendung sogenannter Hartmasken (hard masks). Beispiele finden sich in dem Artikel: "Evaluation of an advanced dual hard mask stack for high resolution pattern transfer" von J. Paul, M. Rudolph, S. Riedel, X. Thrun, S. Wege und C. Hohle in: Proc. of SPIE Vol. 8685 86850V-1 bis 86850V-11. Der Prozess ist relativ aufwändig und teuer. Außerdem kann jeder zusätzliche Prozessschritt zu zusätzlichen Kantenplatzierungsfehlern der auf dem Substrat erzeugten Strukturen führen. US2010272967 A1 offenbart ein Substrat mit einer ersten und einer zweiten Fotolackschicht. Die erste Fotolackschicht wird unter Verwendung einer ersten Maske mit einer ersten Wellenlänge lithographisch belichtet. Anschließend wird die zweite Fotolackschicht mittels einer zweiten Maske und einer zweiten Wellenlänge belichtet, wobei die Strahlung mit der zweiten Wellenlänge durch die mit der ersten Wellenlänge belichteten Bereiche in der ersten Fotolackschicht hindurchtritt.

US4937619 A offenbart eine Projektionsbelichtungsanlage mit einer Excimerlaser-Strahlquelle. Das Spektrum der von der Strahlquelle emittierten Strahlung weist zwei getrennte Spektrallinien auf mit einem Spektralabstand von 0,01nm bis 0,1 nm.

AUFGABE UND LÖSUNG

Es ist eine Aufgabe der Erfindung, ein Projektionsbelichtungsverfahren bereitzustellen, das es erlaubt, eine relativ dicke strahlungsempfindliche Schicht auf einem zu belichtenden Substrat so zu belichten, dass über die gesamte Dicke der Schicht ein belichtetes Volumen mit positionsrichtigen, scharfen Konturen erzeugbar ist. Es ist eine weitere Aufgabe, eine zur Durchführung des Verfahrens geeignete Projektionsbelichtungsanlage bereitzustellen.

Zur Lösung dieser Aufgabe stellt die Erfindung ein Projektionsbelichtungsverfahren mit den Merkmalen von Anspruch 1 bereit. Weiterhin wird eine zur Durchführung des Projektionsbelichtungsverfahrens geeignete Projektionsbelichtungsanlage mit den Merkmalen von Anspruch 9 bereitgestellt. Vorteilhafte Weiterbildungen sind in den abhängigen Ansprüchen angegeben.

Bei dem Projektionsbelichtungsverfahren wird das Substrat mit einem strahlungsempfindlichen bzw. fotosensitiven Mehrschichtsystem beschichtet. Das Mehrschichtsystem weist eine erste Fotolackschicht sowie eine zweite Fotolackschicht auf, die zwischen der ersten Fotolackschicht und dem Substrat angeordnet ist. Die erste Fotolackschicht befindet sich also näher an der Strahlungseintrittsseite bzw. weiter entfernt vom Substrat als die zweite Fotolackschicht.

Die erste Fotolackschicht besteht aus einem ersten Fotolackmaterial, während die zweite Fotolackschicht aus einem zweiten Fotolackmaterial besteht. Die Fotolackschichten werden separat aufgetragen, so dass unterschiedliche Fotolackmaterialien für die erste und die zweite Fotolackschicht verwendet werden können. Dadurch bestehen viele Freiheitsgrade zur Gestaltung des Schichtaufbaus des Mehrschichtsystems.

Bei vielen Ausführungsformen unterscheiden sich das erste und das zweite Fotolackmaterial. Die Unterschiede betreffen besonders die spektrale Sensitivitätscharakteristik der Fotolackmaterialien bzw. deren wellenlängenabhängiges Absorptionsverhalten. Es gibt auch Ausführungsformen, bei denen für die erste und die zweite Fotolackschicht dasselbe Fotolackmaterial verwendet werden kann.

Der Begriff "Sensitivität" bezeichnet im Rahmen dieser Anmeldung die Wahrscheinlichkeit dafür, dass ein einfallendes Photon einer gegebenen Wellenlänge zu einer erwünschten fotochemischen Reaktion in der Fotolackschicht führt. Eine Fotolackschicht ist in diesem Sinne für einen bestimmten Wellenlängenbereich sensitiv, wenn die Strahlung aus dem Wellenlängenbereich derart in dem Fotolackmaterial absorbiert wird, dass dadurch eine fotochemische Reaktion ausgelöst wird, die Eigenschaften des belichteten Volumens des Fotolackmaterials, insbesondere die Löslichkeit des Fotolackmaterials, gegenüber dem nicht belichteten Volumen so verändert, dass in nachfolgenden Prozessschritten belichtete Abschnitte und unbelichtete Abschnitte sich unterschiedlich verhalten.

Das erste Fotolackmaterial, welches weiter vom Substrat entfernt angeordnet ist, weist in einem ersten Wellenlängenbereich eine relativ hohe erste Sensitivität und in einem von dem ersten Wellenlängenbereich separaten zweiten Wellenlängenbereich eine relativ zur ersten Sensitivität geringere zweite Sensitivität auf. Das erste Fotolackmaterial soll in dem ersten Wellenlängenbereich eine belichtungsgeeignete (d.h. für die Belichtung im Sinne des vorhergehenden Absatzes geeignete) erste Sensitivität aufweisen.

Das zweite Fotolackmaterial soll in dem zweiten Wellenlängenbereich eine belichtungsgeeignete (d.h. für die Belichtung geeignete) zweite Sensitivität aufweisen. Eine "belichtungsgeeignete" zweite Sensitivität liegt insbesondere dann vor, wenn mindestens 10 % der Photonen des zweiten Wellenlängenbereichs in der zweiten Fotolackschicht absorbiert werden und auf diese Weise eine fotochemische Reaktion auslösen können.

Das mit dem strahlungsempfindlichen Mehrschichtsystem beschichtete Substrat wird in einem effektiven Bildfeld des Projektionsobjektivs mit dem Bild des in der Objektebene angeordneten Musters belichtet. Für die Belichtung wird die Strahlung einer Strahlungsquelle verwendet, die einen Arbeitswellenlängenbereich aufweist, der den ersten Wellenlängenbereich und den zweiten Wellenlängenbereich umfasst.

Für Wellenlängen, die zwischen diesen beiden Wellenlängenbereichen liegen, sollte gelten, dass das Produkt aus Strahlungsintensität und wellenlängenabhängiger Sensitivität des ersten Fotolackmaterials dort deutlich kleinere Werte als im ersten Wellenlängenbereich besitzt. Weiterhin sollte gelten, dass das Produkt aus Strahlungsintensität und wellenlängenabhängiger Sensitivität des zweiten Fotolackmaterials dort deutlich kleinere Werte als im zweiten Wellenlängenbereich besitzt. Für typischerweise verwendete Lichtquellen ist die Veränderung der Strahlungsintensität mit der Wellenlänge stärker als für typische Fotolackmaterialien die Veränderung der Sensitivität mit der Wellenlänge. Dementsprechend ist obige Bedingung meist gut erreichbar, wenn die Strahlungsintensität für Wellenlängen im Bereich zwischen dem ersten und dem zweiten Wellenlängenbereich deutlich kleiner als im ersten und im zweiten Wellenlängenbereich ist. Diese Bedingung führt dann insbesondere dazu, dass zwischen den Schwerpunktswellenlängen des ersten Wellenlängenbereichs und des zweiten Wellenlängenbereichs ein endlicher spektraler Abstand $\Delta\lambda$ liegt.

Bei dem Verfahren wird ein Projektionsobjektiv verwendet, das für den ersten Wellenlängenbereich und den zweiten Wellenlängenbereich derart korrigiert ist, dass ein zu dem ersten Wellenlängenbereich gehörender erster Fokusbereich gegenüber einem zu dem zweiten Wellenlängenbereich gehörigen zweiten Fokusbereich um einen Fokusabstand versetzt ist. Die Lagen des ersten und zweiten Fokusbereichs bzw. der Fokusabstand sind so auf den Schichtaufbau des strahlungsempfindlichen Mehrschichtsystems abgestimmt, dass der erste Fokusbereich innerhalb der ersten Fotolackschicht und der zweite Fokusbereich innerhalb der zweiten Fotolackschicht liegt.

Durch Beschichten des Substrats mit einem fotosensitiven Mehrschichtsystem der beschriebenen Art kann erreicht werden, dass die strahlungsempfindliche Beschichtung auf dem Substrat nicht überall auf alle Wellenlängen der verwendeten Strahlung gleich empfindlich ist, sondern primär dort auf eine bestimmte Wellenlänge empfindlich ist, wo der Fokus der entsprechenden Wellenlänge liegt. Dabei sollte das näher an der Strahlungseintrittsseite liegende erste Fotolackmaterial primär auf Strahlung aus dem ersten Wellenlängenbereich reagieren, so dass die (für die Auslösung der fotochemischen Reaktion relevante) Anzahl der absorbierten Photonen aus dem zweiten Wellenlängenbereich wegen der relativ geringeren zweiten Sensitivität klein gegenüber der Anzahl der absorbierten Photonen der ersten Wellenlänge ist. Das dem Substrat näher liegende zweite Fotolackmaterial bzw. die zweite Fotolackschicht sollte primär auf die Strahlung aus dem zweiten Wellenlängenbereich reagieren, die von der darüber liegenden ersten Fotolackschicht aufgrund der dortigen geringeren Absorption für die zweite Wellenlänge zu einem relativ großen Anteil zur zweiten Fotolackschicht hindurchgelassen bzw. transmittiert wird.

Unter diesen Bedingungen kann sowohl im ersten Fokusbereich innerhalb der ersten Fotolackschicht als auch im zweiten Fokusbereich innerhalb der zweiten Fotolackschicht eine scharf definierte Belichtungszone erzeugt werden, so dass innerhalb des Mehrschichtsystems eine Schärfentiefevergrößerung ohne dadurch bedingte zusätzliche Verwaschung der Übergangsbereiche zwischen belichteten Zonen und unbelichteten Zonen entsteht.

Somit werden mikrolithographische Projektionsbelichtungsverfahren und Projektionsbelichtungsanlagen möglich, mit welchen dickere photosensitive Schichten belichtet werden können, ohne dass es hierbei zu einer Auswaschung oder einem sonstigen Kontrastverlust des Luftbildes kommt.

Bei den Fotolacken kann es sich insbesondere um Fotolacke auf Polymerbasis oder auf Epoxidharzbasis handeln. Ein Fotolack kann als Positivlack oder Negativlack ausgelegt sein. Bei Negativlacken nimmt die Löslichkeit durch Belichten ab, bei Positivlacken vergrößert sich die Löslichkeit durch Belichten.

Vorzugsweise sollte berücksichtigt werden, dass eine Absorption von deutlich mehr als 35 % der Photonen des ersten Wellenlängenbereichs in der ersten Fotolackschicht nachteilig sein kann, da innerhalb der Schicht die Intensität aufgrund der Absorption exponentiell abnimmt und es bei zu starker Absorption zu einer nachteiligen Tiefenabhängigkeit der Dosis kommen kann. Es wird derzeit als vorteilhaft angesehen, wenn zur Erzeugung der ersten Fotolackschicht ein erstes Fotolackmaterial verwendet wird, das so ausgewählt ist, dass innerhalb der ersten Fotolackschicht zwischen 10 % und 60 %, insbesondere zwischen 20% und 40% der Photonen des ersten Wellenlängenbereichs absorbiert werden. Wird die untere Grenze deutlich unterschritten, wird keine ausreichend starke Reaktion zur Veränderung des physikalischchemischen Verhaltens des belichteten Resists erzeugt bzw. die Stärke der Lichtquelle müsste erhöht werden, um zu einer ausreichenden Belichtung zu kommen. Liegt die optische Absorption deutlich oberhalb der Obergrenze, so kann es zu einer deutlich spürbaren Tiefenabhängigkeit der Belichtung innerhalb der ersten Fotolackschicht kommen, wobei die effektive Belichtung in der Nähe der Strahlungseintrittsseite signifikant höher wäre als in größerem Abstand von der Strahlungseintrittsseite. Daher wird es als vorteilhaft angesehen, wenn ein relativ großer Anteil der Strahlung aus dem ersten Wellenlängenbereich in der ersten Fotolackschicht nicht absorbiert, sondern durch diese hindurchgelassen wird.

Vorzugsweise sollten analoge Bedingungen bei der zweiten Fotolackschicht in Bezug auf Strahlung des zweiten Wellenlängenbereichs vorliegen, um die Tiefenabhängigkeit der Dosis zu vermeiden. Zur Erzeugung der zweiten Fotolackschicht kann also ein zweites Fotolackmaterial verwendet werden, das so ausgewählt ist, dass innerhalb der zweiten Fotolackschicht zwischen 10% und 60%, insbesondere zwischen 20% und 40% der Photonen des zweiten Wellenlängenbereichs absorbiert werden.

Die Fotolackmaterialien können im Hinblick auf die bei der Belichtung verwendeten Wellenlängenbereiche nach bestimmten Kriterien für die Sensitivitätscharakteristika ausgewählt werden.

Insbesondere kann es so sein, dass die Anzahl der in der ersten Fotolackschicht absorbierten Photonen des ersten Wellenlängenbereichs mindestens 50%, insbesondere mindestens 100% größer ist als die Anzahl der in der ersten Fotolackschicht absorbierten Photonen des zweiten Wellenlängenbereichs und/oder dass die Anzahl der in der zweiten Fotolackschicht absorbierten Photonen des zweiten Wellenlängenbereichs mindestens 50%, insbesondere mindestens 100% größer ist als die Anzahl der in der zweiten Fotolackschicht absorbierten Photonen des ersten Wellenlängenbereichs.

Vorzugsweise sollte die Auswahl so getroffen werden, dass innerhalb der ersten Fotolackschicht weniger als 30% der Photonen des zweiten Wellenlängenbereichs absorbiert werden.

Beim Beschichtungsprozess kann die erste Fotolackschicht unmittelbar auf die zweite Fotolackschicht aufgebracht werden, so dass die durch die erste Fotolackschicht hindurchgelassene (transmittierte) Strahlung unmittelbar und vollständig in die zweite Fotolackschicht eintritt. Es ist auch möglich, eine dazwischenliegende Zwischenschicht vorzusehen. Bei einer Verfahrensvariante wird beim Beschichten des Substrats zwischen der ersten Fotolackschicht und der zweiten Fotolackschicht eine Farbfilterschicht aus einem Material erzeugt, das in dem zweiten Wellenlängenbereich eine größere Transmission aufweist als im ersten Wellenlängenbereich. Bei dem Material der Farbfilterschicht kann es sich um ein Fotolackmaterial handeln, in welchem die Absorption von Photonen eine photochemische Reaktion auslöst. Dies ist aber nicht zwingend und häufig auch nicht vorgesehen. Es ist ausreichend, wenn die absorbierten Photonen verloren gehen in dem Sinne, dass sie nicht zur substratnäheren zweiten Fotolackschicht gelangen.

Die farbselektive Zwischenschicht (Farbfilterschicht) lässt also mehr Strahlung des zweiten Wellenlängenbereichs in Richtung der zweiten Fotolackschicht durch, während Strahlung des ersten Wellenlängenbereichs zu einem größeren Anteil absorbiert wird. Ein Vorteil dieser Variante liegt darin, dass die dem Substrat nähere zweite Fotolackschicht dann hauptsächlich im Hinblick auf die Absorptionsfähigkeit für Strahlung des zweiten Wellenlängenbereichs ausgewählt werden kann, während das Verhalten gegenüber Strahlung des ersten Wellenlängenbereichs weitgehend beliebig sein kann. Da insoweit weniger Anforderungen an das zweite Fotolackmaterial gestellt werden, können zur Bildung der zweiten Fotolackschicht mehr Fotolackmaterialien verwendet werden als bei Varianten ohne dritte Fotolackschicht.

Insbesondere ist es bei Verwendung einer zwischengeschalteten Farbfilterschicht auch möglich, für die erste Fotolackschicht und die zweite Fotolackschicht dasselbe Fotolackmaterial zu verwenden, wodurch ggf. ein weniger aufwändiger Beschichtungsprozess ermöglicht wird.

Die Schichtdicken der ersten Fotolackschicht und/oder der zweiten Fotolackschicht können in gewissen Grenzen frei gewählt werden. Zur Erzielung besonders guter Prozessergebnisse erscheint es vorteilhaft, wenn die Schichtdicken der ersten Fotolackschicht und/oder der zweiten Fotolackschicht an die Schärfentiefencharakteristik des Projektionsobjektivs bei den verwendeten Wellenlängen angepasst ist. Die Schärfentiefe ist bekanntlich proportional zur Rayleigh-Einheit RU, die als $RU = \lambda/NA^2$ definiert ist, wobei $\lambda$ die betrachtete Wellenlänge und NA die bildseitige numerische Apertur des Projektionsobjektivs ist. Die Schichtdicke der ersten Fotolackschicht sollte vorzugsweise kleiner sein als die Rayleigh-Einheit für die Schwerpunktswellenlänge $\lambda_1$ des ersten Wellenlängenbereichs. Insbesondere wird es als vorteilhaft angesehen, wenn eine Schichtdicke der ersten Fotolackschicht im Bereich von $RU_1$ bis $RU_1/4$ liegt, wobei $RU_1 = \lambda_1/NA^2$, wobei $\lambda_1$ eine Schwerpunktswellenlänge des ersten Wellenlängenbereichs ist. Alternativ oder zusätzlich kann eine entsprechende Bedingung für die Schichtdicke der zweiten Fotolackschicht als Funktion der Schwerpunktswellenlänge $\lambda_2$ des zweiten Wellenlängenbereichs gelten. Ist die Schichtdicke kleiner als das angegebene Intervall, so wird die von der Projektionsbelichtungsanlage angebotene Schärfentiefe nicht voll ausgenutzt, d.h., die Fotolackschicht ist dünner als sie sein könnte und kann daher im der Belichtung nachfolgenden Ätzprozessschritt darunterliegende Substratbereiche weniger lang und/oder gut schützen, als es eigentlich möglich wäre. Ist die Schichtdicke größer als dieses Intervall, so kommt es zu einer Verschlechterung des Bildkontrastes in mindestens Teilbereichen der Schicht.

Alternativ oder zusätzlich ist eine Optimierung unter Berücksichtigung der jeweiligen Schwerpunktswellenlängen $\lambda$ der Wellenlängenbereiche möglich. Die Schichtdicken können mindestens so groß sein wie die jeweiligen Schwerpunktswellenlängen. Die Schichtdicken können z.B. im Bereich zwischen 100% und 400% der jeweiligen Schwerpunktswellenlänge liegen. Für Projektionsbelichtungsanlagen mit einer bildseitigen Apertur, die deutlich höher als die heutzutage im Wellenlängenbereich zwischen 350 nm und 450 nm gebräuchlichen Werte von bis zu 0,6 liegen, können die Schichtdicken auch dünnere Werte annehmen.

Bei Verwendung vieler geeigneter Fotolacke kann die Schichtdicke der ersten Fotolackschicht und/oder der zweiten Fotolackschicht im Bereich von ca. 50 nm bis ca. 1500 nm liegen, insbesondere im Bereich von 100 nm bis 1000 nm.

Besonders randscharfe Belichtungen über größere Tiefen ergeben sich weiterhin dann, wenn das Projektionsobjektiv derart ausgelegt ist, dass der Fokusabstand im Bereich von $RU_M$ bis $RU_M/4$ liegt, wobei $RU_M = \lambda_M/NA^2$, wobei $\lambda_M$ eine aus dem ersten und zweiten Wellenlängenbereich gemittelte Arbeitswellenlänge und NA die bildseitige numerische Apertur des Projektionsobjektivs ist. Bei Einhaltung diesen Bedingungen sind die axial versetzt liegenden Fokusbereiche in der Regel gut im Inneren der jeweils zugehörigen Fotolackschichten mit Abstand von den Schichtgrenzflächen zu platzieren.

Wie schon erwähnt, sollte zwischen den Schwerpunktswellenlängen des ersten und des zweiten Wellenlängenbereichs ein endlicher spektraler Abstand $\Delta\lambda$ liegen, der beispielsweise mindestens 10 nm betragen kann. Dadurch lassen sich die chemisch-physikalischen Vorgänge in den unterschiedlichen Schichten des Mehrschichtsystems unabhängig voneinander beeinflussen und gezielt steuern. Größere spektrale Abstände $\Delta\lambda$, beispielsweise im Bereich zwi-schen 15 nm und 50 nm, können vorteilhaft sein, da dadurch in den spektralen Absorptionscharakteristika der grundsätzlich verfügbaren Fotolackmaterialien spektral separate Bereiche mit den gewünschten unterschiedlichen Sensitivitätseigenschaften gut genutzt werden können.

Der Fokusabstand der Projektionsbelichtungsanlage für die verschiedenen Wellenlängenbereiche und die Schichtdicken der einzelnen Fotolackschichten sind vorteilhafterweise aneinander angepasst. Der Abstand der Fokuslagen für den ersten Wellenlängenbereich und den zweiten Wellenlängenbereich unterscheidet sich vorzugsweise um maximal 50%, insbesondere um maximal 20% oder 10% von der halben Summe der Schichtdicken der Fotolackschichten. Der Fokusabstand (Abstand der Fokuslagen) kann zum Beispiel im Bereich zwischen der einfachen und zehnfachen typischen Wellenlänge liegen, wobei die typische Wellenlänge zum Beispiel durch eine über alle Wellenlängenbereiche gemittelten Wellenlänge gegeben sein kann.

Insbesondere bei Anwendungen, bei denen die Erzeugung relativ grober Strukturen angestrebt wird, sind keine Laser als Strahlungsquelle erforderlich. Vielmehr kann es so sein, dass als Strahlungsquelle eine Quecksilberdampflampe verwendet wird, wobei der erste Wellenlängenbereich genau eine der Quecksilberlinien mit Schwerpunktswellenlänge bei ca. 365 nm (i-Linie), ca. 405 nm (h-Linie) und ca. 436 nm (g-Linie) enthält und der zweite Wellenlängenbereich genau eine andere der Quecksilberlinien enthält. Das Emissionsspektrum einer Quecksilberdampflampe stellt ohne weitere Maßnahmen anstelle eines kontinuierlichen breiten Spektrums diskrete und spektral voneinander deutlich separierte Schwerpunktswellenlängen zur Verfügung.

Bei bevorzugten Ausführungsbeispielen werden genau zwei unterschiedliche Wellenlängenbereiche für die Belichtung genutzt (Zweiwellenlängenbelichtung). Dies bringt unter anderem den Vorteil eines relativ einfachen Schichtaufbaus und entsprechend einfacher Beschichtungsprozesse. Die Erfindung kann jedoch auf eine größere Anzahl von Arbeitswellenbereichen und Fotolackschichten erweitert werden, z.B. auf drei, vier, fünf oder mehr Wellenlängenbereiche und eine daran angepasste Zahl von Fotolackschichten unterschiedlicher Fotolackmaterialien. Eine vorteilhafte Situation kann vorliegen, wenn die Anzahl der Arbeitswellenlängenbereiche gleich der Anzahl starker Emissionslinien der primären Strahlungsquelle ist, so dass z.B. bei Verwendung einer Quecksilberdampflampe die Verwendung von drei Arbeitswellenlängenbereichen vorteilhaft sein kann. Die Anordnung kann so sein, dass die n-te Fotolackschicht, wobei kleine Werte von n weiter vom Substrat entfernt liegen, im n-ten Arbeitswellenlängenbereich eine für den Lithographieprozess ausreichende Sensitivität besitzt, während die erste bis (n-1)-te Fotolackschicht im Wesentlichen nur auf den ersten bis (n-1)-ten Arbeitswellenlängenbereich empfindlich sind.

Die in dieser Anmeldung erstmals beschriebenen Substrate mit einem strahlungsempfindlichen Mehrschichtsystem bestimmter Eigenschaften versetzen den Nutzer in die Lage, die Vorteile des beanspruchten Projektionsbelichtungsverfahrens zu nutzen.

Die Erfindung betrifft auch eine Projektionsbelichtungsanlage, die hinsichtlich ihrer Strahlungsquelle und des Projektionsobjektivs derart ausgelegt ist, dass damit das beschriebene Projektionsbelichtungsverfahren durchgeführt werden kann.

KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind.

Fig. 1      zeigt Komponenten einer Mikrolithographie-Projektionsbelichtungsanlage bei der Belichtung eines Substrats, das mit einem photosensitiven Mehrschichtsystem beschichtet ist;

Fig. 2    zeigt schematisch ein typisches Emissionsspektrum einer Quecksilberdampflampe;

Fig. 3    zeigt ein schematisches Detail eines Ausschnitts eines zweischichtigen Mehrschichtsystems, das mit Strahlung aus zwei separaten Wellenlängenbereichen in zueinander versetzt liegenden Fokusbereichen belichtet wird;

Fig. 4    zeigt schematisch einen Schichtaufbau eines fotosensitiven Mehrschichtsystems mit zwei unmittelbar aufeinanderliegenden Fotolackschichten;

Fig. 5    zeigt schematisch einen Schichtaufbau eines fotosensitiven Mehrschichtsystems mit drei unmittelbar aufeinanderliegenden Fotolackschichten;

Fig. 6A    zeigt ein Diagramm mit Absorptionskurven einiger kommerziell verfügbarer Fotolackmaterialien zur Verwendung im Rahmen von Ausführungsbeispielen der Erfindung;

Fig. 6B    zeigt ein Diagramm, welches die Abhängigkeit des Anteils absorbierter Strahlungsenergie von der Schichtdicke für verschiedene Absorptionskoeffizienten angibt;

Fig. 7    zeigt ein Projektionsobjektiv gemäß einem ersten Ausführungsbeispiel; und

Fig. 8    zeigt ein Projektionsobjektiv gemäß einem zweiten Ausführungsbeispiel.

## DETAILLIERTE BESCHREIBUNG DER AUSFÜHRUNGSBEISPIELE

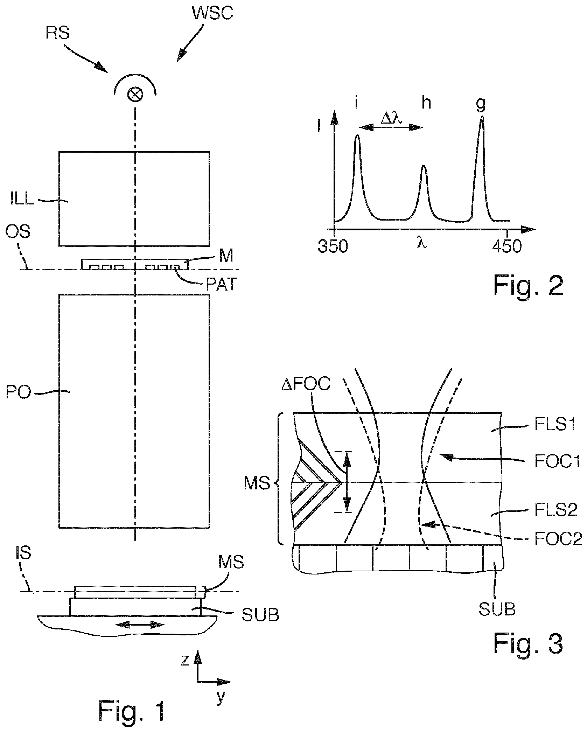

Die schematische Fig. 1 zeigt Komponenten einer Mikrolithographie-Projektionsbelichtungsanlage WSC zur Belichtung eines im Bereich einer Bildebene IS eines Projektionsobjektivs PO angeordneten Substrats mit mindestens einem Bild eines im Bereich einer Objektebene OS des Projektionsobjektivs PO angeordneten Musters PAT einer Maske M.

Die Projektionsbelichtungsanlage wird mit der Strahlung einer Strahlungsquelle RS betrieben. Ein Beleuchtungssystem ILL dient zum Empfang der Strahlung dieser Strahlungsquelle und zur Formung von Beleuchtungsstrahlung, die innerhalb eines Beleuchtungsfeldes auf das Muster der Maske M fällt. Das Projektionsobjektiv PO dient zur Abbildung der Struktur des Musters auf das lichtempfindliche Substrat. Bei dem Substrat kann es sich z.B. um einen Halbleiterwafer handeln. Das zu belichtende Substrat trägt an seiner dem Projektionsobjektiv zugewandten, zu strukturierenden Seite eine strahlungsempfindliche Schicht MS aus Fotolackmaterial (Resistschicht).

Die Projektionsbelichtungsanlage ist vom Scannertyp. Eine nicht dargestellte, auch als "reticle stage" bezeichnete Einrichtung zum Halten und Manipulieren der Maske M (Retikel) ist so konstruiert, dass das Muster PAT in der Objektebene OS des Projektionsobjektivs liegt, welche auch als Retikelebene bezeichnet wird. Die Maske ist in dieser Ebene im Scannerbetrieb in einer Scan-Richtung (y-Richtung) senkrecht zur Referenzachse AX des Projektionsobjektivs mit Hilfe eines Scannerantriebs bewegbar. Das zu belichtende Substrat wird mit Hilfe einer nicht dargestellten Einrichtung getragen, die auch als "wafer stage" bezeichnet wird und einen Scannerantrieb umfasst, um das Substrat synchron mit der Maske M senkrecht zur Referenzachse in einer Scanrichtung (y-Richtung) zu bewegen.

Als Strahlungsquelle RS wird eine Quecksilberdampflampe verwendet. Der Begriff "Strahlungsquelle" soll hier nicht nur die primäre Strahlungsquelle umfassen, von der Licht emittiert wird, sondern auch ggf. vorhandene Einrichtungen wie Filter, Blenden, Bandbreiteneinengungsmodule oder dergleichen, die dazu dienen, das Spektrum der von der primären Strahlungsquelle abgegebenen primären Strahlung vor Eintritt in das Beleuchtungssystem zu verändern.

Fig. 2 zeigt schematisch ein typisches Emissionsspektrum einer Quecksilberdampflampe. Das Emissionsspektrum ist im Bereich zwischen ca. 350 nm und 450 nm gekennzeichnet durch drei Spektrallinien ("Quecksilberlinien") mit relativ hoher Intensität I, zwischen denen spektrale Bereiche mit relativ niedriger Intensität liegen. Die Quecksilberlinie i mit einer Schwerpunktswellenlänge bei ca. 365 nm wird auch als" i-Linie" bezeichnet, die Quecksilberlinie h mit Schwerpunktswellenlänge bei ca. 405 nm auch als "h-Linie" und die Quecksilberlinie g bei ca. 436 nm auch als "g-Linie". Die Quecksilberdampflampe stellt somit in diesem Spektralbereich drei diskrete und spektral voneinander deutlich separierte Schwerpunktswellenlängen zur Verfügung, deren spektraler Abstand $\Delta\lambda$ jeweils deutlich mehr als 20 nm, insbesondere sogar 30 nm oder mehr, beträgt.

Das Projektionsobjektiv PO ist für die drei Wellenlängenbereiche um die g-Linie, die h-Linie und die i-Linie des Quecksilbers herum korrigiert. Dies bedeutet u.a., dass mit jeder der drei Wellenlängen eine hinreichend scharfe beugungsbegrenzte Abbildung des Musters der Maske auf das Substrat möglich ist. Insbesondere ist der Abbildungsmaßstab für Licht dieser drei Linien identisch. Allerdings fallen die besten Einstellebenen bzw. Fokusbereiche der drei Wellenlängen in Axialrichtung (d.h. parallel zur Achse AX) nicht zusammen. Vielmehr sind die primäre chromatische Längsaberration und/oder die sekundäre chromatische Längsaberration so eingestellt, dass diese nicht verschwinden, sondern einen kleinen endlichen Wert aufweisen, so dass die besten Einstellebenen für die drei Schwerpunktswellenlängen jeweils um einem endlichen Betrag, z.B. in der Größenordnung einer Rayleigh-Einheit axial gegeneinander verschoben sind. Diese Abweichung wird auch als "Fokusabstand" ($\Delta$FOC) bezeichnet.

Das mit Hilfe des Projektionsobjektivs durchführbare Projektionsbelichtungsverfahren nutzt diesen Umstand in besonderer Weise, was u.a. im Zusammenhang mit Fig. 3 noch näher erläutert wird.

Bei der Vorbereitung des Substrats für die Belichtung wird das Substrat an seiner zu strukturierenden bzw. der Belichtung auszusetzenden Seite mit einer strahlungsempfindlichen Schicht in Form eines strahlungsempfindlichen Mehrschichtsystem MS beschichtet. Das Mehrschichtsystem MS umfasst eine erste Fotolackschicht FLS1, die aus einem ersten Fotolackmaterial besteht, sowie eine zweite Fotolackschicht FLS2, die aus einem zweiten Fotolackmaterial besteht, das sich von dem ersten Fotolackmaterial chemisch und in seinen photochemischen Eigenschaften unterscheidet. Die zweite Fotolackschicht FLS2 ist zwischen der ersten Fotolackschicht FLS1 und dem Substrat SUB angeordnet. Dadurch erreicht die aus dem austrittsseitigen Ende des Projektionsobjektivs austretende Projektionsstrahlung zunächst die erste Fotolackschicht FLS1. Danach erreicht derjenige Strahlungsanteil, der in der ersten Fotolackschicht nicht absorbiert wird, die zweite Fotolackschicht FLS2. Unterschiede zwischen den beiden Fotolackschichten liegen vor allem in der Abhängigkeit der Sensitivität der Fotolackmaterialien von der Wellenlänge.

Das erste Fotolackmaterial ist so ausgewählt, dass es in einem ersten Wellenlängenbereich um die Schwerpunktwellenlänge $\lambda_1$ eine relativ hohe Sensitivität hat, so dass die Wahrscheinlichkeit, dass ein einfallendes Photon aus dem ersten Wellenlängenbereich mit relativ hoher Wahrscheinlichkeit eine erwünschte fotochemische Reaktion in der ersten Fotolackschicht verursacht, relativ hoch ist. In einem zweiten Wellenlängenbereich um die Schwerpunktwellenlänge $\lambda_2$ ist die Sensitivität des ersten Fotolackmaterials dagegen relativ zur ersten Sensitivität signifikant geringer, so dass Photonen aus dem zweiten Wellenlängenbereich in der ersten Fotolackschicht FLS1 weniger stark absorbiert werden als diejenigen des ersten Wellenlängenbereichs und somit zu einem größeren Anteil zur darunterliegenden zweiten Fotolackschicht FLS2 durchdringen können. Das zweite Fotolackmaterial, aus welchem die zweite Fotolackschicht FLS2 aufgebaut ist, hat in diesem zweiten Wellenlängenbereich eine für die Belichtung ausreichende zweite Sensitivität, so dass die zweite Wellenlänge innerhalb der zweiten Fotolackschicht FLS2 in deutlichem Ausmaß eine fotochemische Reaktion verursachen kann, die die Eigenschaften des zweiten Fotolackmaterials, insbesondere seine Löslichkeit, verändern.

Ein solcher mehrschichtiger Aufbau einer fotosensitiven Schicht ist mit herkömmlichen Beschichtungstechnologien mit hoher Güte herstellbar. Beispielsweise können nacheinander zwei Schichten unterschiedlicher Fotolackmaterialien mittels spin-coatings auf dem Substrat aufgebracht werden.

In der Belichtungsphase des Projektionsbelichtungsverfahrens wird das mit dem strahlungsempfindlichen Mehrschichtsystem MS belegte Substrat mit Hilfe der Projektionsbelichtungsanlage belichtet. Dabei wird die Strahlungsquelle RS so eingestellt, dass gleichzeitig bzw. synchron zwei der drei Quecksilberlinien benutzt werden, also beispielsweise die i-Linie in Kombination mit der h-Linie, die i-Linie in Kombination mit der g-Linie oder die h-Linie in Kombination mit der g-Linie. Eine der beiden ausgewählten Linien entspricht dann dem ersten Wellenlängenbereich, die zweite ausgewählte Linie dem zweiten Wellenlängenbereich.

In dem schematischen Beispielsfall der Fig. 1 bis 3 ist das Projektionsobjektiv PO optisch so korrigiert, dass bei geeigneter Anordnung des zu belichteten Substrats in Bezug auf die Bildebene IS des Projektionsobjektivs die beste Einstellebene der ersten Wellenlänge, also der erste Fokusbereich FOC1, im Inneren der substratfernen ersten Fotolackschicht FLS1 liegt, während die beste Einstellebene der zweiten Wellenlänge, also der zweite Fokusbereich FOC2, näher bei Substrat innerhalb der zweiten Fotolackschicht FLS2 liegt.

Aufgrund der unterschiedlichen Fokuslagen wird somit innerhalb der ersten Fotolackschicht FLS1 das aus der Belichtung resultierende Lackbild vor allem durch das Luftbild des ersten Wellenlängenbereiches um $\lambda_1$ bestimmt, während das Luftbild des zweiten Wellenlängenbereichs um $\lambda_2$ das Lackbild näher beim Substrat in der zweiten Fotolackschicht FLS2 bestimmt.

Durch den mehrschichtigen Aufbau der fotosensitiven Schicht wird erreicht, dass die fotosensitive Schicht nicht überall, d.h. über die gesamte Tiefe (in z-Richtung), für alle Wellenlängen gleich empfindlich ist, sondern primär dort auf einen bestimmten Wellenlängenbereich oder eine bestimmte Wellenlänge empfindlich ist, wo der Fokusbereich der entsprechenden Wellenlänge liegt. Unter diesen Bedingungen kann ein solches Luftbild mit zwei axial versetzten Fokuslagen für zwei diskrete, in einem spektralen Abstand zueinander liegende Wellenlängen zu einer Schärfentiefevergrößerung innerhalb des relativ dicken Resists ohne zusätzliche Verwaschungen führen.

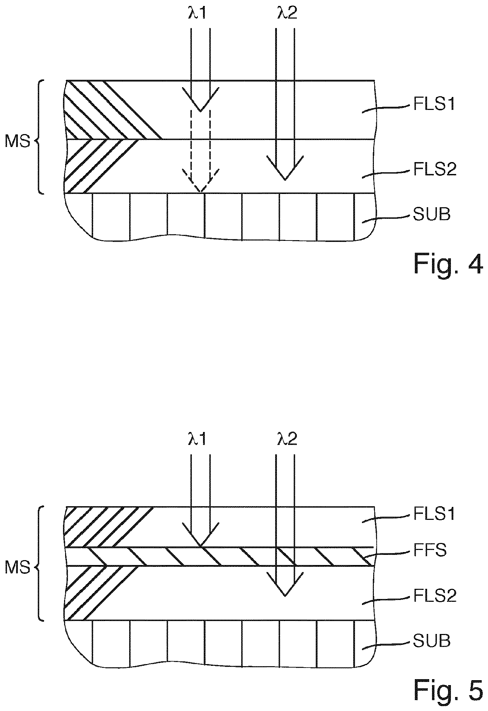

Anhand der Fig. 4 und 5 werden zwei Alternativen zum grundsätzlichen Schichtaufbau eines fotosensitiven Mehrschichtsystems MS zur Verwendung im Rahmen von Ausführungsbeispielen der Erfindung erläutert. Fig. 4 zeigt schematische eine Variante, bei der zunächst die zweite Fotolackschicht FLS2 auf das Substrat aufgebracht wird und danach die erste Fotolackschicht ohne Zwischenschaltung einer weiteren Fotolackschicht direkt auf die zweite Fotolackschicht aufgebracht wird. Die beiden Fotolackschichten können beispielsweise mittels spin-coatings nacheinander aufgebracht werden.

Die substratferne erste Fotolackschicht FLS1, die auch als "obere" Schicht bezeichnet werden kann, sollte in diesem Fall aus einem Fotolackmaterial bestehen, welches Licht aus dem ersten Wellenlängenbereich (mit Schwerpunktswellenlänge $\lambda_1$) relativ stark absorbiert, aber Licht aus dem zweiten Wellenlängenbereich (mit Schwerpunktswellenlänge $\lambda_2$) überwiegend zur zweiten Fotolackschicht FLS2 durchlässt. Bei einer Fotolackschicht sind im Rahmen dieser Anmeldung die beiden Begriffe "absorbieren" und "eine fotochemische Reaktion auslösen" in diesem Zusammenhang im Wesentlichen gleichbedeutend. Die dem Substrat nähere zweite Fotolackschicht FLS2, die auch als "untere" Schicht bezeichnet wird, sollte aus einem Fotolackmaterial bestehen, welches Licht des zweiten Wellenlängenbereichs ausreichend stark absorbiert, aber Licht des ersten Wellenlängenbereichs überwiegend transmittiert.

Die Forderung nach größerer Transmission (also relativ geringer Sensitivität) für den ersten Wellenlängenbereich kommt daher, dass ein größerer Anteil des Lichts der ersten Wellenlänge die obere Fotolackschicht (erste Fotolackschicht FLS1) durchdringen sollte, da ansonsten eine zu starke Tiefenabhängigkeit der Belichtung innerhalb der ersten Fotolackschicht FLS1 resultieren könnte. Es hat sich als zweckmäßig herausgestellt, wenn für die erste Fotolackschicht ein erstes Fotolackmaterial verwendet wird, dessen spezifische Absorption bzw. Sensitivität so gewählt wird, dass innerhalb der ersten Fotolackschicht FLS1 zwischen ca. 10% und ca. 30% bis 55% der Photonen des ersten Wellenlängenbereichs absorbiert werden, so dass ein überwiegender Anteil des ersten Wellenlängenbereichs transmittiert wird.

Eine alternative Variante ist in Fig. 5 schematisch dargestellt. Bei diesem Ausführungsbeispiel ist zwischen der substratferneren ersten Fotolackschicht FLS1 und der substratnäheren zweiten Fotolackschicht FLS2 eine Farbfilterschicht FFS aus einem Material angeordnet, das so ausgewählt ist, dass es im zweiten Wellenlängenbereich (der primär für die Belichtung der zweiten Fotolackschicht FLS2 genutzt werden soll) eine größere Transmission aufweist als im ersten Wellenlängenbereich (der überwiegend für die Belichtung der substratferneren ersten Fotolackschicht FLS1 genutzt werden soll).

Ein Vorteil dieser Variante liegt darin, dass die dem Substrat nähere untere Schicht (zweite Fotolackschicht FLS2) aufgrund des Schutzes durch die vorgeschaltete Farbfilterschicht FFS gegen Licht des ersten Wellenlängenbereichs im Prinzip nur die Eigenschaft erfüllen muss, Licht des zweiten Wellenlängenbereichs ausreichend stark zu absorbieren, also eine relativ hohe zweite Sensitivität aufzuweisen. Die Sensitivität gegenüber dem Licht des ersten Wellenlängenbereichs kann dann beliebig sein, da dieses Licht aufgrund der Blockung durch die Farbfilterschicht FFS nicht im größeren Anteil zur zweiten Fotolackschicht FLS2 gelangen kann. Bei Varianten mit zwischengeschalteter Farbfilterschicht ist es im Prinzip möglich, die erste und die zweite Fotolackschicht aus dem gleichen Fotolackmaterial herzustellen.

Nachfolgend werden zur Veranschaulichung der hier erläuterten Prinzipien einige konkrete Ausführungsbeispiele für "Zweiwellenlängen-Belichtungen" angegeben.

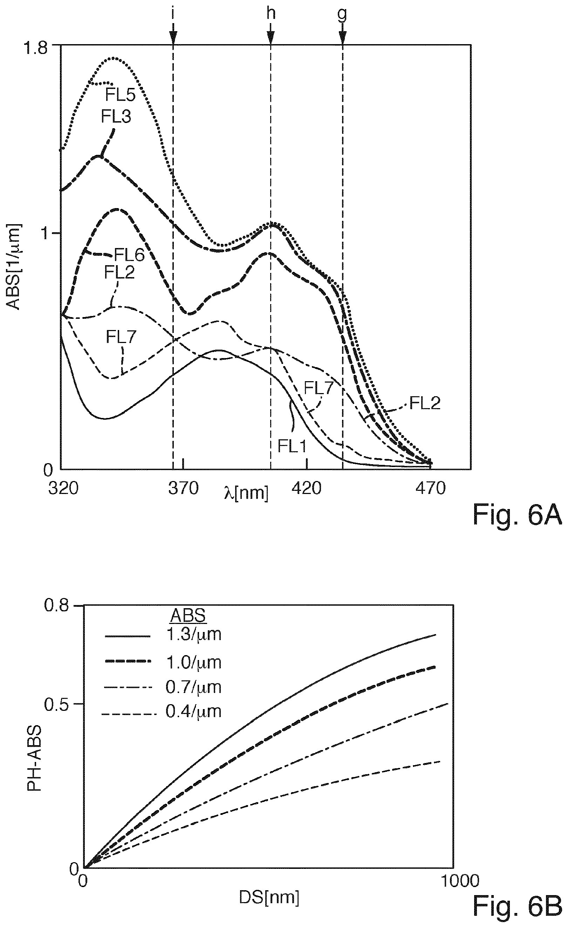

Das Diagramm in Fig. 6A zeigt schematisch Absorptionskurven einiger kommerziell verfügbarer Fotolackmaterialien bzw. Resistmaterialien. In dem Diagramm ist jeweils der Absorptionskoeffizient ABS (in Einheiten von $1/\mu m$) als Funktion der Wellenlänge $\lambda$ (in [nm]) angegeben. Die Kurven repräsentieren Fotolacke der Fa. MicroChemicals gemäß der Quelle: http//www.microchemicals.com/downloads/application_notes.html. Die Zuordnung der Kurvenbezeichnungen FL1, FL2, ... FL7 zu den kommerziellen Bezeichnungen AZ$^®$XXX ist wie folgt: FL1=AZ$^®$ 9260; FL2=AZ$^®$ 4562; FL3$^®$=AZ 6632; FL5=AZ$^®$ 1512HS; FL6=AZ$^®$ 701MiR und FL7=AZ$^®$ 5214E.

Aus den Absorptionskoeffizienten der verwendeten Fotolacke kann berechnet werden, welcher Anteil der einfallenden Photonen der entsprechenden Wellenlänge in Abhängigkeit von der Schichtdicke absorbiert wird. Die Absorptionskoeffizienten werden normalerweise in der Einheit $1/\mu m$ angegeben. Typische Werte liegen im Bereich von $0,5/\mu m$ bis $1/\mu m$. Hieraus ergibt sich, welcher Anteil der auf die Fotolackschicht einfallenden Strahlung in dieser absorbiert wird. Fig. 6B zeigt ein Diagramm, welches die Abhängigkeit des Anteils PH-ABS absorbierter Strahlungsenergie von der Schichtdicke DS für vier verschiedene Absorptionskoeffizienten ABS angibt. Die dargestellten Kurven gelten für eine Belichtung mit kleiner Dosis bzw. mit kleiner Intensität. Nicht chemisch verstärkte Fotolacke, insbesondere also die meistens im Bereich der g-, h- und i-Linie einer Quellsilberlampe verwendeten Fotolacke, zeigen das Phänomen des Ausbleichens ("Bleaching"). Die Absorption von Photonen durch Fotolacke führt hierbei dazu, dass der Fotolack transparenter für weitere einfallende Photonen wird. Für hinreichend starke Lichtdosen, so wie so typischerweise zum Belichtung des Fotolacks verwendet werden, wird also effektiv ein geringerer Energieanteil als in der Abbildung dargestellt, absorbiert.

Bei einem ersten konkreten Ausführungsbeispiel wird der Schichtaufbau gemäß Fig. 4 gewählt. Die substratnahe zweite Schicht (FLS2) hat eine Schichtdicke von 800 nm und besteht aus AZ$^®$ 4562 (Kurve FL2). Die substratferne erste Schicht FLS1 hat eine Schichtdicke von 800 nm und besteht AZ 9260 (FL1). Bei diesem Ausführungsbeispiel entspricht die h-Linie dem ersten Wellenlängenbereich und die g-Linie dem zweiten Wellenlängenbereich. Die obere Schicht (FLS1) reagiert praktisch nur auf die h-Linie. Die substratnähere untere Schicht (FLS2) reagiert auf die h-Linie und die g-Linie fast gleichstark. Da jedoch ein signifikanter Anteil der h-Linien Strahlung bereits in der oberen Schicht (erster Fotolackschicht FL1) absorbiert worden ist, wird die Belichtung der unteren Schicht (zweite Fotolackschicht FLS2) durch die g-Linienstrahlung dominiert. Dieser erwünschte Effekt wird dadurch verstärkt, dass eine Quecksilberdampflampe in der Regel die g-Linie mit größerer Intensität emittiert als die h-Linie (vgl. Fig. 2).

Bei einem zweiten konkreten Ausführungsbeispiel wird wieder der Schichtaufbau gemäß Fig. 4 gewählt. Bei diesem Ausführungsbeispiel werden zur Belichtung die i-Linie und die g-Linie verwendet. Die substratferne erste Fotolackschicht FLS1 (Schichtdicke 800 nm) besteht aus AZ® 9260 (entsprechend FL1), während die substratnahe zweite Fotolackschicht FLS2 (Schichtdicke 800 nm) aus AZ® 701MiR (entsprechend FL6) besteht. Die substratferne obere Schicht (FLS1) ist gegenüber dem ersten konkreten Beispiel unverändert, die untere Schicht besteht jetzt aus einem Material, das möglichst nur auf Licht der g-Linie reagieren soll. Dieses ist nur eingeschränkt erreichbar, weil typischerweise die etwas energiereicheren Photonen der i-Linie auch Reaktionen auslösen können, die auch von den Photonen der g-Linie ausgelöst werden können. Sinnvoll ist daher die Verwendung eines Fotolackmaterials, welches für die i-Linie ein lokales Minimum der Sensitivität aufweist. Da von der Strahlungsquelle die g-Linie typischerweise mit etwas größerer Intensität als die i-Linie emittiert wird sowie ein größerer Anteil der i-Linien-Photonen bereits in der ersten Fotolackschicht FLS1 absorbiert wird, kann so erreicht werden, dass die Absorption von Photonen in der zweiten Fotolackschicht FLS2 durch Photonen der g-Linie dominiert wird.

Bei einem dritten konkreten Ausführungsbeispiel wird wieder der Schichtaufbau gemäß Fig. 4 gewählt. Bei diesem Ausführungsbeispiel werden zur Belichtung die i-Linie und die g-Linie verwendet. Im Vergleich zum zweiten Ausführungsbeispiel wurde die obere Schicht (FLS1) bei unveränderter Schichtdicke (800 nm) durch AZ® 1512HS (entsprechend Kurve FL5) ersetzt, das im Vergleich zu AZ® 9260 (entsprechend FL1) eine höhere Absorption für i-Licht aufweist. Die zweite Fotolackschicht bleibt unverändert. Durch die Modifikation wird erreicht, dass weniger i-Linien-Photonen zur Belichtung notwendig sind, was als erwünschter Effekt angesehen werden kann. Allerdings werden auch g-Linien-Photonen stärker zur Belichtung der oberen Schicht beitragen, was ggf. unerwünscht sein kann.

Bei einem vierten konkreten Ausführungsbeispiel wird der Schichtaufbau gemäß Fig. 5 gewählt, also mit einer zwischengeschalteten Farbfilterschicht FFS. Diese Ausführungsbeispiel für die g-Linie (als zweite Wellenlänge) und die i-Linie (als erste Wellenlänge) verwendet somit eine zusätzliche farbselektive Zwischenschicht. Die obere Schicht (erste Fotolackschicht FLS1) aus AZ®5214E (entsprechend FL7) hat eine Schichtdicke von 800 nm und ist praktisch nicht für g-Linienlicht sensitiv, so dass praktisch nur i-Linienlicht zur Belichtung beiträgt. Die untere Schicht (zweite Fotolackschicht FLS2) aus AZ®6632 (entsprechend FL3) hat eine Schichtdicke von 800 nm und ist in erster Linie auf Grund ihrer g-Linien-Sensitivät ausgesucht, d.h., ihr Verhalten bei i-Linienstrahlung ist irrelevant. Zwischen diesen beiden Resists wird als Zwischenschicht eine 90 nm dicke Farbfilterschicht FFS verwendet, die die i-Linie ausfiltert bzw. blockiert, so dass i-Linien-Licht praktisch nicht zur zweiten Fotolackschicht FLS2 durchdringen kann.

Als Farbfilterschicht kann z.B. ein Bottom-Anti-Reflective-Coating (BARC) für i-Linie verwendet werden. Ein BARC soll die Rückreflexion des entsprechenden Lichts verhindern und ist daher für die entsprechende Wellenlänge (hier: i-Linie) stark absorbierend. Ein weiterer Wirkungsmechanismus eines BARC liegt in der Interferenz durch multiple Reflexion der Strahlung innerhalb des BARC. Bei einer bestimmten Schichtdicke der Farbfilterschicht FFS wird der Rückreflex der i-Linienstrahlung in die obere Schicht (FLS1) unterdrückt. Rückreflektiertes Licht kann durch Überlagerung mit dem einfallenden Licht im Resist unerwünschte Überlagerungen, welche als Swing-Curves bekannt sind, erzeugen. Diese können insbesondere bei dicken Lackschichten auftreten. Bei AZ® BARLi II 90 liegt die Dicke, bei der diese Unterdrückung der Rückreflexion geschieht bei 90 nm.

Wird die Dicke eines BARC um 50% erhöht (im Beispiel auf 135 nm), so kommt es nicht zu einer minimalen, sondern zu einer maximalen Rückreflexion von i-Linienstrahlung. Dieses hat den Nachteil, dass Swing-Curves stärker werden können (was unter Umständen bei einer dünneren Schicht nur schwache Auswirkungen hat), bietet aber dafür den Vorteil einer verbesserten Blockung, so dass weniger i-Linienstrahlung unerwünschter Weise durch die Farbfilterschicht hindurchdringen kann.

Zur Durchführung des Verfahrens können unterschiedliche Typen von Projektionsobjektiven verwendet werden. Beispielsweise kann ein dioptrisches Projektionsobjektiv verwendet werden, also ein Projektionsobjektiv, bei dem alle mit Brechkraft behafteten optischen Elemente (insbesondere Linsen) aus einem im Arbeitswellenlängenbereich transparenten Material bestehen. Es ist auch möglich, dass das Projektionsobjektiv ein katadioptrisches Projektionsobjektiv ist, also ein Projektionsobjektiv, bei dem im Projektionsstrahlengang zusätzlich zu transparenten optischen Elementen (z.B. Linsen) mindestens ein gekrümmter Spiegel, insbesondere ein Konkavspiegel, vorgesehen ist.

Geeignete katadioptrische Projektionsobjektive können z.B. aus den in der US 7,760,452 B2 gezeigten Beispielen durch Modifikationen zur Veränderung der primären und/oder sekundären chromatischen Längsaberration entwickelt werden. Vorzugsweise werden Reduktionsobjektive verwendet, also solche Projektionsobjektive, die das Muster in verkleinerndem Maßstab (z.B. 1:4 oder 1:5) auf die Bildebene bzw. das Substrat abbilden. Bildseitige numerische Aperturen NA im Bereich von NA=0.5 oder NA=0.6 bis zu NA=0.8 oder NA= 0.93 geben häufig einen guten Kompromiss zwischen erzielbarer Auflösung und Herstellungsaufwand der Projektionsbelichtungsanlage, da die notwendige Anzahl und Größe der optischen Elemente in der Projektionsoptik signifikant mit der numerischen Apertur ansteigen.

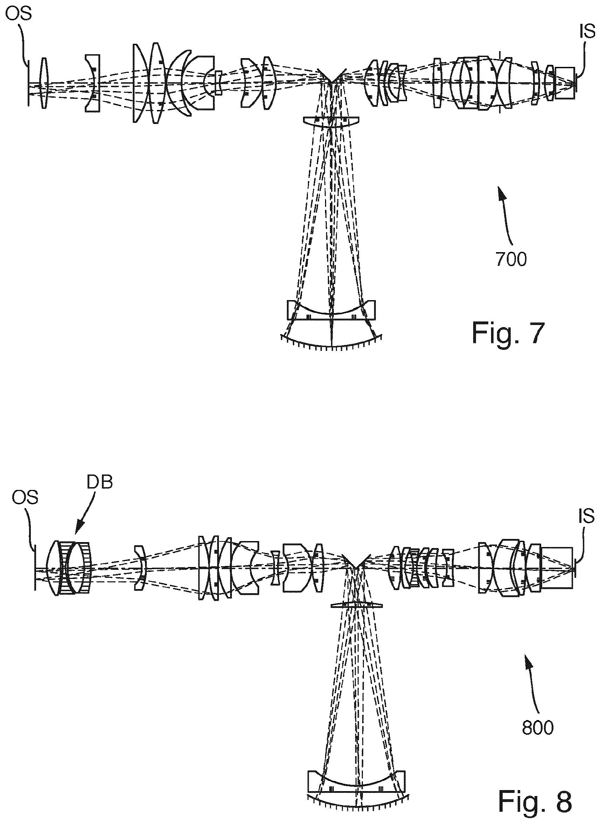

Die Fig. 7 und Fig. 8 zeigen Ausführungsbeispiele, die extrem breitbandig korrigiert sind. Über die allgemeinen Korrekturprinzipien der Designs gibt die US 7,760,452 B2 Auskunft. Die Designs sind aus der Ausführungsform von Fig. 3a aus US 7,760,452 B2 entwickelt worden. Die Designs sind für die Wellenlängenbereiche um die g- (436nm), h- (405nm) und i-Linien (365nm) des Quecksilbers herum korrigiert.

Die einzige Modifikation gegenüber der US 7,760,452 B2 ist, dass die primäre und/oder sekundäre chromatische Längsaberration nicht verschwinden, sondern einen kleinen Wert aufweisen, so dass die besten Einstellebenen für die drei Schwerpunktswellenlängen um einen endlichen Betrag (z.B. von der Größenordnung einer Rayleigh Einheit RU) axial gegeneinander verschoben sind. Da sowohl primäre als auch sekundäre chromatische Längsaberration in den Designs korrigierbar ist (sonst wäre die spektrale Breitbandigkeit nicht gewährleistet), ist die Abfolge der Fokusebenen a priori frei wählbar.

In den Beispielen der Fig. 7 und 8 (bzw. Tabellen 7, 7A, 8, 8A) liegt die Einstellebene der i-linie um ca. 1.5$\mu$m hinter, die der g-Linie um 1.5$\mu$m vor der mittleren h-Linie (d.h. der Fokusabstand beträgt jeweils ca. 1.5 $\mu$m). Dies kann durch leichte Verstimmung der primären chromatischen Längsaberration erreicht werden. Die Verstimmung ist so marginal, dass strukturelle Maßnahmen, die das vorliegende Design vom Stand der Technik aus US 7,760,452 B2 unterscheiden, kaum erkennbar sind.

Das Ausführungsbeispiel des Projektionsobjektivs 700 in Fig. 7 ähnelt dem Design aus Fig. 3a in US 7,760,452 B2 sehr, mit dem Unterschied der geringen Verstimmung der primären chromatischen Längsaberration. Im Design aus Fig. 7 definiert die Blendenebene im retikelnahen Systemteil die Pupillenlage im System. Diese Blendenebene wird durch den gesamten vorderen Systemteil in den Retikelraum abgebildet. Diese Abbildung ist jedoch chromatisch deutlich unterkorrigiert, mit der Folge, dass die Lage der Eintrittspupille mit der Wellenlänge variiert und somit das System für verschiedene Wellenlängen verschiedene Telezentrieverhalten am Retikel zeigt.

Eine chromatische Korrektur der Pupillenabbildung kann erreicht werden, indem lukennahe Objektivteile, d.h. insbesondere die Objektivteile nahe des Retikels und der Zwischenbilder, chromatisch korrigiert werden. In dem Beispiel des Projektionsobjektivs 800 von Fig. 8 konnte diese chromatische Korrektur der Pupillenabbildung durch die Verwendung eines achromatischen, überkorrigierenden Dubletts DB unmittelbar hinter der Retikelebeme erreicht werden.

Die Spezifikationen der in den Zeichnungsfiguren gezeigten Projektionsobjektive sind in den am Ende der Beschreibung zusammengestellten Tabellen angegeben, deren Nummerierung jeweils der Nummerierung der entsprechenden Zeichnungsfigur entspricht.

In den Tabellen ist die Spezifikation des jeweiligen Designs in tabellarischer Form zusammengefasst. Dabei gibt Spalte "SURF" die Nummer einer brechenden oder auf andere Weise ausgezeichneten Fläche, Spalte "RADIUS" den Radius r der Fläche (in mm), Spalte "THICKNESS" den als Dicke bezeichneten Abstand d der Fläche zur nachfolgenden Fläche (in mm) und Spalte "MATERIAL" das Material der optischen Komponenten an. Spalten "INDEX1", INDEX2" und "INDEX3" 5 geben den Brechungsindex des Materials bei der Design-Arbeitswellenlänge 405,0 nm (INDEX1) sowie bei 365,5 nm (INDEX2) und 436,0 nm (INDEX3) an. In Spalte "SEMIDIAM" sind die nutzbaren, freien Radien bzw. die halben freien optischen Durchmesser der Linsen (in mm) bzw. der optischen Elemente angegeben. Der Radius r=0 (in der Spalte "RADIUS") entspricht einer Ebene. Einige optische Flächen sind asphärisch. Tabellen mit Zusatz "A" geben die entsprechenden Asphärendaten an, wobei sich die asphärischen Flächen nach folgender Vorschrift berechnen:

$$p(h)=[((1/r)h^2)/(1+SQRT(1-(1+K)(1/r)^2h^2))]+C1*h^4+C2*h^6+....$$

Dabei gibt der Kehrwert (1/r) des Radius die Flächenkrümmung und h den Abstand eines Flächenpunktes von der optischen Achse (d.h. die Strahlhöhe) an. Somit gibt p(h) die Pfeilhöhe, d.h. den Abstand des Flächenpunktes vom Flächenscheitel in z-Richtung (Richtung der optischen Achse). Die Konstanten K, C1, C2, ... sind in den Tabellen mit Zusatz "A" wiedergegeben. Ist die konische Konstante K gleich 0, so kann obige Formel vereinfacht werden zu:

$$p(h)=r - SQRT(r^2–h^2)+C1*h^4+C2*h^6+....$$

Die Projektionsobjektive der Ausführungsbeispiele sind für eine bildseitige numerische Apertur NA=0.5 ausgelegt. Die Objekthöhe beträgt jeweils 62 mm.

**Tabelle 7**

| SURF | RADIUS | THICKNESS | MATERIAL | INDEX1 | INDEX2 | INDEX3 | SEMIDIAM. |
|---|---|---|---|---|---|---|---|
| 0 | 0,000000 | 30,999239 | | | | | 62,0 |
| 1 | 373,037363 | 20,185220 | SILUV | 1,469595 | 1,474477 | 1,466705 | 67,0 |

(fortgesetzt)

| SURF | RADIUS | THICKNESS | MATERIAL | INDEX1 | INDEX2 | INDEX3 | SEMIDIAM. |
|---|---|---|---|---|---|---|---|
| 2 | -541,760232 | 129,422263 | | | | | 67,3 |
| 3 | -115,028462 | 9,999705 | SILUV | 1,469595 | 1,474477 | 1,466705 | 65,7 |
| 4 | 782,096792 | 97,474648 | | | | | 72,3 |
| 5 | 5509,601771 | 40,383963 | SILUV | 1,469595 | 1,474477 | 1,466705 | 105,7 |
| 6 | -203,776252 | 0,998640 | | | | | 107,6 |
| 7 | 529,048728 | 46,003379 | SILUV | 1,469595 | 1,474477 | 1,466705 | 109,7 |
| 8 | -237,562584 | 0,998896 | | | | | 109,2 |
| 9 | 103,370551 | 41,199723 | SILUV | 1,469595 | 1,474477 | 1,466705 | 90,2 |
| 10 | 186,249835 | 0,999230 | | | | | 84,9 |
| 11 | 88,404710 | 59,547566 | SILUV | 1,469595 | 1,474477 | 1,466705 | 72,8 |
| 12 | 46,514366 | 34,120437 | | | | | 37,9 |
| 13 | -654,141211 | 9,999203 | LLF1 | 1,569035 | 1,579164 | 1,563301 | 28,7 |
| 14 | 69,841318 | 70,409654 | | | | | 23,6 |
| 15 | -130,842157 | 45,398433 | SILUV | 1,469595 | 1,474477 | 1,466705 | 53,2 |
| 16 | -77,580480 | 0,999277 | | | | | 63,7 |
| 17 | 262,716015 | 35,541566 | SILUV | 1,469595 | 1,474477 | 1,466705 | 69,8 |
| 18 | -155,985117 | 154,304081 | | | | | 70,6 |
| 19 | 0,000000 | -98,001733 | REFL | | | | 58,2 |
| 20 | 953,262426 | -30,000163 | SILUV | 1,469595 | 1,474477 | 1,466705 | 70,1 |
| 21 | 184,528258 | -539,193237 | | | | | 72,9 |
| 22 | 156,598936 | -15,000000 | SILUV | 1,469595 | 1,474477 | 1,466705 | 100,3 |
| 23 | -4650,355141 | -79,514276 | | | | | 114,9 |
| 24 | 309,705734 | 79,514276 | REFL | | | | 135,5 |
| 25 | -4650,355141 | 15,000000 | SILUV | 1,469595 | 1,474477 | 1,466705 | 114,9 |
| 26 | 156,598936 | 539,193237 | | | | | 100,3 |
| 27 | 184,528258 | 30,000163 | SILUV | 1,469595 | 1,474477 | 1,466705 | 72,9 |
| 28 | 953,262426 | 98,001733 | | | | | 70,1 |
| 29 | 0,000000 | -90,998413 | REFL | | | | 56,0 |
| 30 | -92,968839 | -38,386976 | SILUV | 1,469595 | 1,474477 | 1,466705 | 65,0 |
| 31 | 420,362199 | -0,998431 | | | | | 61,5 |
| 32 | -150,858410 | -13,920740 | SILUV | 1,469595 | 1,474477 | 1,466705 | 55,4 |
| 33 | -215,655266 | -0,998336 | | | | | 52,6 |
| 34 | -84,111220 | -9,998184 | SILUV | 1,469595 | 1,474477 | 1,466705 | 49,4 |
| 35 | -55,013593 | -30,578858 | | | | | 43,1 |
| 36 | 147,410830 | -9,999697 | LLF1 | 1,569035 | 1,579164 | 1,563301 | 42,7 |
| 37 | -151,310806 | -81,051032 | | | | | 43,5 |
| 38 | -466,983054 | -23,006065 | SILUV | 1,469595 | 1,474477 | 1,466705 | 62,1 |
| 39 | 1467,053388 | -23,999990 | | | | | 63,8 |

(fortgesetzt)

| SURF | RADIUS | THICKNESS | MATERIAL | INDEX1 | INDEX2 | INDEX3 | SEMIDIAM. |
|---|---|---|---|---|---|---|---|
| 40 | -118,647192 | -27,288965 | SILUV | 1,469595 | 1,474477 | 1,466705 | 66,8 |
| 41 | -252,483473 | -28,266766 | | | | | 64,3 |
| 42 | 194,359802 | -19,929542 | SILUV | 1,469595 | 1,474477 | 1,466705 | 63,8 |
| 43 | 974,991650 | -1,024234 | | | | | 67,8 |
| 44 | -3810,639438 | -49,866014 | SILUV | 1,469595 | 1,474477 | 1,466705 | 68,3 |
| 45 | 112,221510 | -0,998878 | | | | | 70,8 |
| 46 | -107,009990 | -33,102042 | SILUV | 1,469595 | 1,474477 | 1,466705 | 72,1 |
| 47 | -379,868857 | 23,900689 | | | | | 70,0 |
| 48 | 0,000000 | -94,616886 | | | | | 70,8 |
| 49 | 199,265941 | -12,660793 | SILUV | 1,469595 | 1,474477 | 1,466705 | 60,1 |
| 50 | 102,694472 | -16,977099 | | | | | 59,9 |
| 51 | -146,212382 | -24,054677 | SILUV | 1,469595 | 1,474477 | 1,466705 | 57,2 |
| 52 | 2651,110005 | -2,997905 | | | | | 56,3 |
| 53 | -376,636246 | -53,957363 | SILUV | 1,469595 | 1,474477 | 1,466705 | 49,3 |
| 54 | 0,000000 | -6,000000 | | | | | 30,3 |
| 55 | 0,000000 | 0,000000 | | | | | 15,5 |

**Tabelle 7A**

| SRF | 3 | 8 | 15 | 17 | 20 |
|---|---|---|---|---|---|
| K | 0 | 0 | 0 | 0 | 0 |
| C1 | -2,887581E-09 | 2,754947E-08 | 3,143831E-07 | -1,809897E-07 | 1,822000E-08 |
| C2 | 3,639247E-12 | -1,317980E-14 | -7,166394E-11 | 1,503296E-11 | 8,194813E-13 |
| C3 | 2,299133E-16 | -4,450129E-19 | 1,771371E-14 | -2,059691E-15 | -1,148136E-16 |
| C4 | -5,519562E-20 | 2,195748E-22 | -3,823760E-18 | 2,658837E-19 | 2,081649E-20 |
| C5 | 1,539807E-23 | -9,937547E-27 | 5,827682E-22 | -2,414969E-23 | -1,612146E-24 |
| C6 | -1,297884E-27 | 5,245909E-32 | -4,128253E-26 | 9,808433E-28 | 3,106512E-29 |
| | | | | | |
| SRF | 23 | 25 | 28 | 30 | 39 |
| K | 0 | 0 | 0 | 0 | 0 |
| C1 | 1,567459E-08 | 1,567459E-08 | 1,822000E-08 | 9,365817E-08 | 1,098453E-07 |
| C2 | -3,503920E-13 | -3,503920E-13 | 8,194813E-13 | 8,740047E-12 | 8,465549E-12 |
| C3 | 8,470661E-18 | 8,470661E-18 | -1,148136E-16 | 9,918516E-16 | 3,642033E-16 |
| C4 | 9,577812E-23 | 9,577812E-23 | 2,081649E-20 | -3,869321E-20 | 7,611225E-20 |
| | | | | | |
| C5 | -1,749301E-26 | -1,749301E-26 | -1,612146E-24 | 2,251688E-23 | -2,433024E-23 |
| C6 | 4,530886E-31 | 4,530886E-31 | 3,106512E-29 | -5,451527E-28 | 2,063618E-27 |
| | | | | | |

(fortgesetzt)

| SRF | 42 | 45 | 50 | 52 | |
|---|---|---|---|---|---|
| K | 0 | 0 | 0 | 0 | |
| C1 | 3,195231E-07 | -4,771259E-08 | -6,368113E-07 | 1,386434E-06 | |
| C2 | 6,720416E-12 | -5,962148E-12 | 5,631346E-11 | -3,592014E-10 | |
| C3 | -1,618440E-15 | -6,642272E-16 | -2,607509E-14 | 7,319747E-14 | |
| C4 | 5,783600E-20 | -1,571383E-20 | 5,566104E-18 | -1,403844E-17 | |
| C5 | -9,870658E-23 | -5,245497E-24 | -1,067046E-21 | 3,109777E-21 | |
| C6 | 1,248526E-26 | 7,806076E-28 | 8,389797E-26 | -4,692062E-25 | |

**Tabelle 8**

| SURF | RADIUS | THICKNESS | MATERIAL | INDEX1 | INDEX2 | INDEX3 | SEMIDIAM. |
|---|---|---|---|---|---|---|---|
| 0 | 0,000000 | 30,994669 | | | | | 62,0 |
| 1 | 125,641356 | 36,993327 | SILUV | 1,469595 | 1,474477 | 1,466705 | 68,6 |
| 2 | -346,945721 | 6,623566 | | | | | 67,4 |
| 3 | -242,098198 | 9,998993 | LLF1 | 1,569035 | 1,579164 | 1,563301 | 66,2 |
| 4 | 109,729798 | 4,680913 | | | | | 63,6 |
| 5 | 117,631569 | 45,328857 | SILUV | 1,469595 | 1,474477 | 1,466705 | 65,1 |
| 6 | -142,684885 | 1,009339 | | | | | 65,1 |
| 7 | -167,247330 | 16,800175 | LLF1 | 1,569035 | 1,579164 | 1,563301 | 64,0 |
| 8 | -371,219100 | 144,028763 | | | | | 63,8 |
| 9 | -66,701122 | 9,999415 | SILUV | 1,469595 | 1,474477 | 1,466705 | 48,7 |
| 10 | -163,310914 | 150,611114 | | | | | 53,6 |
| 11 | -2850,141731 | 22,731693 | SILUV | 1,469595 | 1,474477 | 1,466705 | 80,9 |
| 12 | -237,351495 | 0,999433 | | | | | 82,1 |
| 13 | 262,189826 | 27,438280 | SILUV | 1,469595 | 1,474477 | 1,466705 | 82,5 |
| 14 | -1262,513805 | 0,999073 | | | | | 81,3 |
| 15 | 137,001521 | 31,478056 | SILUV | 1,469595 | 1,474477 | 1,466705 | 77,2 |
| 16 | 2947,559047 | 0,999505 | | | | | 74,5 |
| 17 | 101,266428 | 52,532392 | SILUV | 1,469595 | 1,474477 | 1,466705 | 67,4 |
| 18 | 66,613615 | 67,050232 | | | | | 47,7 |
| 19 | -148,997684 | 9,998622 | LLF1 | 1,569035 | 1,579164 | 1,563301 | 39,8 |
| 20 | 171,702830 | 30,186653 | | | | | 39,5 |
| 21 | -58,042538 | 64,531134 | SILUV | 1,469595 | 1,474477 | 1,466705 | 40,6 |
| 22 | -81,864968 | 0,997141 | | | | | 58,9 |
| 23 | 110,035450 | 32,146941 | SILUV | 1,469595 | 1,474477 | 1,466705 | 61,2 |
| 24 | -379,761919 | 92,777554 | | | | | 59,9 |
| 25 | 0,000000 | -98,001733 | REFL | | | | 44,0 |
| 26 | -368,077865 | -16,386146 | SILUV | 1,469595 | 1,474477 | 1,466705 | 65,1 |

(fortgesetzt)

| SURF | RADIUS | THICKNESS | MATERIAL | INDEX1 | INDEX2 | INDEX3 | SEMIDIAM. |
|---|---|---|---|---|---|---|---|
| 27 | 735,840504 | -499,853075 | | | | | 65,9 |
| 28 | 166,867022 | -15,000000 | SILUV | 1,469595 | 1,474477 | 1,466705 | 115,4 |
| 29 | -1827,676972 | -43,702658 | | | | | 137,4 |
| 30 | 267,329987 | 43,702658 | REFL | | | | 139,4 |
| 31 | -1827,676972 | 15,000000 | SILUV | 1,469595 | 1,474477 | 1,466705 | 137,4 |
| 32 | 166,867022 | 499,853075 | | | | | 115,4 |
| 33 | 735,840504 | 16,386146 | SILUV | 1,469595 | 1,474477 | 1,466705 | 65,9 |
| 34 | -368,077865 | 98,001733 | | | | | 65,1 |
| 35 | 0,000000 | -90,999365 | REFL | | | | 43,8 |
| 36 | -102,248394 | -33,274995 | SILUV | 1,469595 | 1,474477 | 1,466705 | 52,4 |
| 37 | 281,691798 | -0,998017 | | | | | 51,1 |
| 38 | -189,941635 | -9,999060 | SILUV | 1,469595 | 1,474477 | 1,466705 | 48,3 |
| 39 | -104,251757 | -22,250631 | | | | | 44,9 |
| 40 | 117,698060 | -9,998375 | LLF1 | 1,569035 | 1,579164 | 1,563301 | 44,4 |
| 41 | -240,955384 | -0,994228 | | | | | 45,8 |
| 42 | -76,766716 | -21,285981 | SILUV | 1,469595 | 1,474477 | 1,466705 | 48,7 |
| 43 | -135,907039 | -3,499905 | | | | | 46,8 |
| 44 | -74,898007 | -27,735790 | SILUV | 1,469595 | 1,474477 | 1,466705 | 47,4 |
| 45 | -264,831457 | -29,416214 | | | | | 44,3 |
| 46 | 116,358117 | -14,999625 | SILUV | 1,469595 | 1,474477 | 1,466705 | 40,7 |
| 47 | -254,633674 | -75,160401 | | | | | 42,8 |
| 48 | -895,744632 | -40,753240 | SILUV | 1,469595 | 1,474477 | 1,466705 | 64,0 |
| 49 | 102,686711 | -0,999128 | | | | | 68,2 |
| 50 | -128,022889 | -47,652176 | SILUV | 1,469595 | 1,474477 | 1,466705 | 73,2 |
| 51 | -121,088770 | 74,579730 | | | | | 66,5 |
| 52 | 0,000000 | -82,341970 | | | | | 58,7 |
| 53 | -146,606909 | -33,307943 | SILUV | 1,469595 | 1,474477 | 1,466705 | 66,9 |
| 54 | 182,689561 | -0,998718 | | | | | 65,8 |
| 55 | -125,099703 | -39,073806 | SILUV | 1,469595 | 1,474477 | 1,466705 | 60,8 |
| 56 | -239,782755 | -2,132900 | | | | | 52,9 |
| 57 | -339,123355 | -90,180480 | SILUV | 1,469595 | 1,474477 | 1,466705 | 51,0 |
| 58 | 0,000000 | -6,000000 | | | | | 19,1 |
| 59 | 0,000000 | 0,000000 | | | | | 15,5 |

**Tabelle 8A**

| SRF | 9 | 14 | 21 | 23 | 26 |
|---|---|---|---|---|---|
| K | 0 | 0 | 0 | 0 | 0 |

(fortgesetzt)

| | | | | | |
|---|---|---|---|---|---|
| C1 | -1,281898E-08 | 1,679216E-08 | 6,826803E-07 | -2,805214E-07 | 3,480613E-08 |
| C2 | 1,919413E-11 | 4,261661E-13 | -1,860015E-10 | 2,209415E-11 | 8,117968E-13 |
| C3 | 3,145778E-15 | 4,839749E-18 | 5,575586E-14 | -4, 288884E-15 | -3,187963E-16 |
| C4 | 1,261029E-18 | -2,479651E-21 | -2,676663E-17 | 6,340941E-19 | 6,252202E-20 |
| C5 | -1,352670E-22 | 3,536604E-25 | 8,461123E-21 | -7,584238E-23 | -7,098223E-24 |
| C6 | 1,228604E-25 | -1,718615E-29 | -2,541758E-24 | 4,568623E-27 | 3, 972776E- 28 |
| | | | | | |
| SRF | 29 | 31 | 34 | 36 | 43 |
| K | 0 | 0 | 0 | 0 | 0 |
| C1 | 1,770146E-08 | 1,770146E-08 | 3,480613E-08 | -8,917220E-08 | -6,391990E-07 |
| C2 | -4,023066E-13 | -4,023066E-13 | 8,117968E-13 | 5,242418E-12 | 1,571295E-12 |
| C3 | 1,150398E-17 | 1,150398E-17 | -3,187963E-16 | 4,491605E-16 | 1, 236663E-14 |
| C4 | -3,317847E-22 | -3,317847E-22 | 6,252202E-20 | 2,858433E-19 | 1,908698E-18 |
| C5 | 7,488276E-27 | 7,488276E-27 | -7,098223E-24 | -9,489181E-23 | 5,567362E-22 |
| C6 | -8,623680E-32 | -8,623680E-32 | 3,972776E-28 | 1,751423E-26 | 1,532807E-25 |
| | | | | | |
| SRF | 46 | 49 | 54 | 56 | |
| K | 0 | 0 | 0 | 0 | |
| C1 | 5,488053E-07 | -9,297460E-08 | -3,351087E-07 | 8,076670E-07 | |
| C2 | 1,327211E-10 | 3,041983E-13 | 2,424051E-11 | -1,286212E-10 | |
| C3 | 3,542785E-14 | -3,996630E-16 | -4,207967E-15 | 2,319293E-15 | |
| C4 | -5,251783E-18 | -5,695200E-20 | 7,703106E-19 | 3,014464E-18 | |
| C5 | 9,721746E-21 | 4,861379E-24 | -8,915061E-23 | -6,281739E-22 | |
| C6 | -2,187672E-24 | -7,767578E-28 | 5,063466E-27 | 4,132915E-26 | |

**Patentansprüche**

1.  Projektionsbelichtungsverfahren zur Belichtung eines im Bereich einer Bildebene eines Projektionsobjektivs angeordneten Substrats mit mindestens einem Bild eines im Bereich einer Objektebene des Projektionsobjektivs angeordneten Musters einer Maske mit folgenden Schritten:

    Beschichten des Substrats (SUB) mit einem strahlungsempfindlichen Mehrschichtsystem (MS), das eine erste Fotolackschicht (FLS1) aus einem ersten Fotolackmaterial und zwischen der ersten Fotolackschicht und dem Substrat eine separat aufgebrachte zweite Fotolackschicht (FLS2) aus einem zweiten Fotolackmaterial umfasst, wobei
    das erste Fotolackmaterial in einem ersten Wellenlängenbereich eine relativ hohe erste Sensitivität und in einem von dem ersten Wellenlängenbereich separaten zweiten Wellenlängenbereich eine relativ zur ersten Sensitivität geringere zweite Sensitivität aufweist, und
    das zweite Fotolackmaterial in dem zweiten Wellenlängenbereich eine belichtungsgeeignete zweite Sensitivität aufweist;
    Belichten des mit dem strahlungsempfindlichen Mehrschichtsystem (MS) beschichteten Substrats mit dem Bild des Musters unter Verwendung von Strahlung einer Strahlungsquelle (RS) mit einem Arbeitswellenlängenbereich, der den ersten Wellenlängenbereich und den zweiten Wellenlängenbereich umfasst;
    wobei ein Projektionsobjektiv (PO) verwendet wird, das für den ersten Wellenlängenbereich und den zweiten Wellenlängenbereich derart korrigiert ist, dass ein zu dem ersten Wellenlängenbereich gehöriger erster Fokusbereich (FOC1) gegenüber einem zu dem zweiten Wellenlängenbereich gehörigen zweiten Fokusbereich (FOC2) um einen Fokusabstand (ΔFOC) versetzt ist,
wobei der erste Fokusbereich (FOC1) innerhalb der ersten Fotolackschicht (FLS1) und der zweite Fokusbereich (FOC2) innerhalb der zweiten Fotolackschicht (FLS2) liegt.

2. Projektionsbelichtungsverfahren nach Anspruch 1, worin das erste Fotolackmaterial und das zweite Fotolackmaterial unterschiedliche spektrale Sensitivitätscharakteristika aufweisen.

3. Projektionsbelichtungsverfahren nach Anspruch 1 oder 2, worin zur Erzeugung der ersten Fotolackschicht (FLS1) ein erstes Fotolackmaterial verwendet wird, das so ausgewählt ist, dass innerhalb der ersten Fotolackschicht zwischen 10% und 60% der Photonen des ersten Wellenlängenbereichs absorbiert werden und/oder worin zur Erzeugung der zweiten Fotolackschicht (FLS2) ein zweites Fotolackmaterial verwendet wird, das so ausgewählt ist, dass innerhalb der zweiten Fotolackschicht zwischen 10% und 60% der Photonen des zweiten Wellenlängenbereichs absorbiert werden, und/oder worin zur Erzeugung der ersten Fotolackschicht (FLS1) ein erstes Fotolackmaterial verwendet wird, das derart ausgewählt ist, dass eine Anzahl der in der ersten Fotolackschicht absorbierten Photonen des ersten Wellenlängenbereichs mindestens 50%, insbesondere mindestens 100% größer ist als die Anzahl der in der ersten Fotolackschicht absorbierten Photonen des zweiten Wellenlängenbereichs und/oder worin zur Erzeugung der zweiten Fotolackschicht (FLS2) ein zweites Fotolackmaterial verwendet wird, das derart ausgewählt ist, dass die Anzahl der in der zweiten Fotolackschicht absorbierten Photonen des zweiten Wellenlängenbereichs mindestens 50%, insbesondere mindestens 100% größer ist als die Anzahl der in der zweiten Fotolackschicht absorbierten Photonen des ersten Wellenlängenbereichs, und/oder worin zur Erzeugung der ersten Fotolackschicht (FLS1) ein erstes Fotolackmaterial verwendet wird, das derart ausgewählt ist, dass innerhalb der ersten Fotolackschicht (FLS1) weniger als 30% der Photonen des zweiten Wellenlängenbereichs absorbiert werden.

4. Projektionsbelichtungsverfahren nach einem der vorhergehenden Ansprüche, worin beim Beschichten des Substrats (SUB) zwischen der ersten Fotolackschicht (FLS1) und der zweiten Fotolackschicht (FLS2) eine Farbfilterschicht (FFS) aus einem Material erzeugt wird, das in dem zweiten Wellenlängenbereich eine größere Transmission aufweist als im ersten Wellenlängenbereich.

5. Projektionsbelichtungsverfahren nach einem der vorhergehenden Ansprüche, worin das Projektionsobjektiv (PO) derart ausgelegt ist, dass der Fokusabstand (ΔFOC) im Bereich von $RU_M$ bis $RU_M/4$ liegt, wobei $RU_M = \lambda_M/NA^2$, wobei $\lambda_M$ eine aus dem ersten und zweiten Wellenlängenbereich gemittelte Arbeitswellenlänge und NA die bildseitige numerische Apertur des Projektionsobjektivs ist.

6. Projektionsbelichtungsverfahren nach einem der vorhergehenden Ansprüche, worin die Beschichtung derart durchgeführt wird, dass eine Schichtdicke der ersten Fotolackschicht (FLS1) im Bereich von $RU_1$ bis $RU_1/4$ liegt, wobei $RU_1 = \lambda_1/NA^2$, wobei $\lambda_1$ eine Schwerpunktswellenlänge des ersten Wellenlängenbereichs und NA die bildseitige numerische Apertur des Projektionsobjektivs ist und/oder derart, dass eine Schichtdicke der zweiten Fotolackschicht (FLS2) im Bereich von $RU_2$ bis $RU_2/4$ liegt, wobei $RU_2 = \lambda_2/NA^2$, wobei $\lambda_2$ eine Schwerpunktswellenlänge des zweiten Wellenlängenbereichs und NA die bildseitige numerische Apertur des Projektionsobjektivs ist

7. Projektionsbelichtungsverfahren nach einem der vorhergehenden Ansprüche, worin die Beschichtung derart durchgeführt wird, dass die Schichtdicke der ersten Fotolackschicht (FLS1) und/oder die Schichtdicke der zweiten Fotolackschicht (FLS2) im Bereich von 50 nm bis 1500 nm liegt, insbesondere im Bereich von 100 nm bis 1000 nm.

8. Projektionsbelichtungsverfahren nach einem der vorhergehenden Ansprüche, worin ein spektraler Abstand Δλ zwischen den Schwerpunktswellenlängen des ersten Wellenlängenbereichs und des zweiten Wellenlängenbereichs mindestens 10 nm beträgt und/oder worin eine Quecksilberdampflampe als Strahlungsquelle (RS) verwendet wird, wobei der erste Wellenlängenbereich genau eine der Quecksilberlinien mit Schwerpunktswellenlänge bei ca. 365 nm (i-Linie), ca. 405 nm (h-Linie) und ca. 436 nm (g-Linie) enthält und der zweite Wellenlängenbereich genau eine andere der Quecksilberlinien enthält.

9. Projektionsbelichtungsanlage zur Belichtung eines im Bereich einer Bildebene eines Projektionsobjektivs angeordneten Substrats mit mindestens einem Bild eines im Bereich einer Objektebene des Projektionsobjektivs angeordneten Musters einer Maske mit:

einer primären Strahlungsquelle (RS) zur Abgabe von Strahlung in einem Arbeitswellenlängenbereich, der einen ersten Wellenlängenbereich und einen von dem ersten Wellenlängenbereich separaten zweiten Wellenlängenbereich umfasst;

einem Beleuchtungssystem (ILL) zum Empfang der Strahlung und zur Erzeugung einer auf die Maske (M) gerichteten Beleuchtungsstrahlung;

einem Projektionsobjektiv (PO) zur Erzeugung eines Bildes des Musters im Bereich der Bildfläche (IS) des Projektionsobjektivs, wobei das Projektionsobjektiv mindestens für den ersten Wellenlängenbereich und den zweiten Wellenlängenbereich derart korrigiert ist, dass mit jeder Wellenlänge des ersten und des zweiten Wellenlängenbereichs eine scharfe beugungsbegrenzte Abbildung des Musters auf das Substrat bei identischem Abbildungsmaßstab möglich ist,

**dadurch gekennzeichnet, dass**

ein spektraler Abstand Δλ zwischen den Schwerpunktswellenlängen des ersten Wellenlängenbereichs und des zweiten Wellenlängenbereichs mindestens 10 nm beträgt und

ein zu dem ersten Wellenlängenbereich gehörender erster Fokusbereich (FOC1) gegenüber einem zu dem zweiten Wellenlängenbereich gehörigen zweiten Fokusbereich (FOC2) um einen Fokusabstand (ΔFOC) versetzt ist.

10. Projektionsbelichtungsanlage nach Anspruch 9, worin das Projektionsobjektiv (PO) derart ausgelegt ist, dass der Fokusabstand (ΔFOC) im Bereich von $RU_M$ bis $RU_M/4$ liegt, wobei $RU_M = \lambda_M/NA^2$, wobei $\lambda_M$ eine aus dem ersten und zweiten Wellenlängenbereich gemittelte Arbeitswellenlänge und NA die bildseitige numerische Apertur des Projektionsobjektivs ist.

11. Projektionsbelichtungsanlage nach Anspruch 9 oder 10, worin die Strahlungsquelle (RS) eine Quecksilberdampflampe aufweist, wobei der erste Wellenlängenbereich genau eine der Quecksilberlinien mit Schwerpunktswellenlänge bei ca. 365 nm (i-Linie), ca. 405 nm (h-Linie) und ca. 436 nm (g-Linie) enthält und der zweite Wellenlängenbereich genau eine andere der Quecksilberlinien enthält.

## Claims

1. Projection exposure method for exposing a substrate arranged in the region of an image plane of a projection lens with at least one image of a pattern of a mask arranged in the region of an object plane of the projection lens, including the following steps:

coating the substrate (SUB) with a radiation-sensitive multilayer system (MS), which comprises a first photoresist layer (FLS1) composed of a first photoresist material and, between the first photoresist layer and the substrate, a separately applied second photoresist layer (FLS2) composed of a second photoresist material, wherein

the first photoresist material has a relatively high first sensitivity in a first wavelength range and has a second sensitivity that is lower in relation to the first sensitivity in a second wavelength range, which is separate from the first wavelength range, and

the second photoresist material has an exposure-appropriate second sensitivity in the second wavelength range; exposing the substrate coated with the radiation-sensitive multilayer system (MS) with the image of the pattern using radiation from a radiation source (RS) with a working wavelength range comprising the first wavelength range and the second wavelength range;

wherein a projection lens (PO) is used, which is corrected for the first wavelength range and the second wavelength range such that a first focus region (FOCI) associated with the first wavelength range is offset with respect to a second focus region (FOC2) associated with the second wavelength range by a focus distance (ΔFOC), wherein the first focus region (FOCI) lies within the first photoresist layer (FLS1) and the second focus region (FOC2) lies within the second photoresist layer (FLS2).

2. Projection exposure method according to Claim 1, wherein the first photoresist material and the second photoresist material have different spectral sensitivity characteristics.

3. Projection exposure method according to Claim 1 or 2, wherein, for producing the first photoresist layer (FLS1), a first photoresist material is used that is selected such that between 10% and 60% of the photons of the first wavelength range are absorbed within the first photoresist layer, and/or wherein, for producing the second photoresist layer (FLS2), a second photoresist material is used that is selected such that between 10% and 60% of the photons of the second wavelength range are absorbed within the second photoresist layer, and/or wherein, for producing the first photoresist layer (FLS1), a first photoresist material is used that is selected such that a number of the photons of the first wavelength range absorbed in the first photoresist layer is at least 50%, in particular at least 100%, greater than the number of the photons of the second wavelength range absorbed in the first photoresist layer, and/or wherein, for producing the second photoresist layer (FLS2), a second photoresist material is used that is selected such that the number of the photons of the second wavelength range absorbed in the second photoresist layer is at least 50%, in particular at least 100%, greater than the number of the photons of the first wavelength range absorbed in the second photoresist layer, and/or wherein, for producing the first photoresist layer (FLS1), a first photoresist material is used that is selected such that less than 30% of the photons of the second wavelength range are absorbed within the first photoresist layer (FLS1).

4.  Projection exposure method according to any of the preceding claims, wherein, when coating the substrate (SUB), a colour filter layer (FFS) made of a material that has a greater transmission in the second wavelength range than in the first wavelength range is produced between the first photoresist layer (FLS1) and the second photoresist layer (FLS2).

5.  Projection exposure method according to any of the preceding claims, wherein the projection lens (PO) is designed such that the focus distance ($\Delta$FOC) lies in the range from $RU_M$ to $RU_M/4$, wherein $RU_M = \lambda_M/NA^2$, wherein $\lambda_M$ is a working wavelength averaged from the first and second wavelength ranges and NA is the image-side numerical aperture of the projection lens.

6.  Projection exposure method according to any of the preceding claims, wherein the coating is carried out such that a layer thickness of the first photoresist layer (FLS1) lies in the range from $RU_1$ to $RU_1/4$, wherein $RU_1 = \lambda_1/NA^2$, wherein $\lambda_1$ is a centroid wavelength of the first wavelength range and NA is the image-side numerical aperture of the projection lens, and/or such that a layer thickness of the second photoresist layer (FLS2) lies in the range from $RU_2$ to $RU_2/4$, wherein $RU_2 = A_2/NA^2$, wherein $\lambda_2$ is a centroid wavelength of the second wavelength range and NA is the image-side numerical aperture of the projection lens.

7.  Projection exposure method according to any of the preceding claims, wherein the coating is carried out such that the layer thickness of the first photoresist layer (FLS1) and/or the layer thickness of the second photoresist layer (FLS2) lies in the range from 50 nm to 1500 nm, in particular in the range from 100 nm to 1000 nm.

8.  Projection exposure method according to any of the preceding claims, wherein a spectral distance $\Delta\lambda$ between the centroid wavelengths of the first wavelength range and of the second wavelength range is at least 10 nm, and/or wherein a mercury vapour lamp is used as radiation source (RS), wherein the first wavelength range contains exactly one of the mercury lines with a centroid wavelength at approximately 365 nm (i-line), approximately 405 nm (h-line) and approximately 436 nm (g-line) and the second wavelength range contains exactly one other one of the mercury lines.

9.  Projection exposure apparatus for exposing a substrate arranged in the region of an image plane of a projection lens with at least one image of a pattern of a mask arranged in the region of an object plane of the projection lens, having:

    a primary radiation source (RS) for emitting radiation in a working wavelength range that comprises a first wavelength range and a second wavelength range, which is different from the first wavelength range;
    an illumination system (ILL) for receiving the radiation and for producing illumination radiation that is directed onto the mask (M);
    a projection lens (PO) for producing an image of the pattern in the region of the image surface (IS) of the projection lens, wherein the projection lens is corrected at least for the first wavelength range and the second wavelength range such that sharp diffraction-limited imaging of the pattern onto the substrate with an identical imaging scale is possible with each wavelength of the first and the second wavelength range,
    **characterized in that**
    a spectral distance $\Delta\lambda$ between the centroid wavelengths of the first wavelength range and of the second wavelength range is at least 10 nm and a first focus region (FOC1) associated with the first wavelength range is offset with respect to a second focus region (FOC2) associated with the second wavelength range by a focus distance ($\Delta$FOC).

10. Projection exposure apparatus according to Claim 9, wherein the projection lens (PO) is designed such that the focus distance ($\Delta$FOC) lies in the range from $RU_M$ to $RU_M/4$, wherein $RU_M = \lambda_M/NA^2$, wherein $\lambda_M$ is a working wavelength averaged from the first and second wavelength ranges and NA is the image-side numerical aperture of the projection lens.

11. Projection exposure apparatus according to Claim 9 or 10, wherein the radiation source (RS) has a mercury vapour lamp, wherein the first wavelength range contains exactly one of the mercury lines with a centroid wavelength at approximately 365 nm (i-line), approximately 405 nm (h-line) and approximately 436 nm (g-line) and the second wavelength range contains exactly one other one of the mercury lines.

**Revendications**

1. Procédé d'éclairement par projection destiné à éclairer un substrat, disposé au niveau d'un plan image d'un objectif de projection, avec au moins une image d'un motif d'un masque disposé dans la zone d'un plan objet de l'objectif de projection, ledit procédé comprenant les étapes suivantes :

revêtir le substrat (SUB) avec un système multicouche (MS) sensible aux rayonnements, qui comprend une première couche de résine photosensible (FLS1) comprenant une première résine photosensible et une deuxième couche de résine photosensible (FLS2) comprenant une deuxième résine photosensible et appliquée séparément entre la première couche de résine photosensible et le substrat,
la première résine photosensible présentant une première sensibilité relativement élevée dans une première gamme de longueurs d'onde et une deuxième sensibilité relativement plus faible que la première sensibilité dans une deuxième gamme de longueurs d'onde distincte de la première gamme de longueurs d'onde, et
la deuxième résine photosensible présentant une deuxième sensibilité, adaptée à l'éclairement, dans la deuxième gamme de longueurs d'onde ;
éclairer le substrat revêtu du système multicouche (MS) sensible au rayonnement avec l'image du motif à l'aide d'un rayonnement d'une source de rayonnement (RS) ayant une gamme de longueurs d'onde de travail qui comprend la première gamme de longueurs d'onde et la deuxième gamme de longueurs d'onde ;
un objectif de projection (PO) étant utilisé qui est corrigé pour la première gamme de longueurs d'onde et la deuxième gamme de longueurs d'onde de manière à ce qu'une première gamme de focales (FOC1), appartenant à la première gamme de longueurs d'onde, soit décalée d'une distance focale ($\Delta$FOC) par rapport à la deuxième gamme de focales (FOC1), appartenant à la deuxième gamme de longueurs d'onde,
la première gamme de focales (FOC1) étant située à l'intérieur de la première couche de résine photosensible (FLS1) et la deuxième zone de focales (FOC2) étant située à l'intérieur de la deuxième couche de résine photosensible (FLS2).

2. Procédé d'éclairement par projection selon la revendication 1, la première résine photosensible et la deuxième résine photosensible ayant des caractéristiques de sensibilité spectrale différentes.

3. Procédé d'éclairement par projection selon la revendication 1 ou 2, une première résine photosensible étant utilisée pour produire la première couche de résine photosensible (FLS1) et étant choisie de sorte qu'entre 10 % et 60 % des photons de la première gamme de longueurs d'onde soient absorbés à l'intérieur de la première couche de résine photosensible et/ou une deuxième résine photosensible étant utilisée pour produire la deuxième couche de résine photosensible (FLS2) et étant choisie de sorte qu'entre 10 % et 60 % des photons de la deuxième gamme de longueurs d'onde soient absorbés dans la deuxième couche de résine photosensible et/ou une première résine photosensible étant utilisée pour produire la première couche de résine photosensible (FLS1) et étant choisie de sorte qu'un nombre de photons de la première gamme de longueurs d'onde qui ont été absorbés dans la première couche de résine photosensible soit d'au moins 50 %, en particulier d'au moins 100 % supérieur au nombre de photons de la deuxième gamme de longueurs d'onde qui ont été absorbés dans la première couche de résine photosensible et/ou une deuxième résine photosensible étant utilisée pour produire la deuxième couche de résine photosensible (FLS2) et étant choisie de sorte que le nombre de photons de la deuxième gamme de longueurs d'onde qui ont été absorbés dans la deuxième couche de résine photosensible soit d'au moins 50 %, en particulier d'au moins 100 %, supérieur au nombre de photons de la première gamme de longueurs d'onde qui ont été absorbés dans la deuxième couche de résine photosensible, et/ou une première résine photosensible étant utilisée pour produire la première couche de résine photosensible (FLS1) et étant choisie de sorte que moins de 30 % des photons de la deuxième gamme de longueurs d'onde soient absorbés à l'intérieur de la première couche de résine photosensible (FLS1).

4. Procédé d'éclairement par projection selon l'une des revendications précédentes, une couche de filtre coloré (FFS) étant produite lors du revêtement du substrat (SUB) entre la première couche de résine photosensible (FLS1) et la deuxième couche de résine photosensible (FLS2) à partir d'une matière qui présente une plus grande transmission dans la deuxième gamme de longueurs d'onde que dans la première gamme de longueurs d'onde.

5. Procédé d'éclairement par projection selon l'une des revendications précédentes, l'objectif de projection (PO) étant conçu de sorte que la distance focale ($\Delta$FOC) soit située dans la gamme allant de $RU_M$ à $RU_M/4$, avec $RU_M = \lambda_M/NA^2$, $\lambda_M$ étant une longueur d'onde de travail moyennée à partir de la première et de la deuxième gamme de longueurs d'onde et NA étant l'ouverture numérique côté image de l'objectif de projection.

6. Procédé d'éclairement par projection selon l'une des revendications précédentes, le revêtement étant réalisé de sorte qu'une épaisseur de couche de la première couche de résine photosensible (FLS1) soit dans la gamme allant de $RU_1$ à $RU_1/4$, avec $RU_1 = \lambda_1/NA^2$, $\lambda_1$ étant une longueur d'onde d'intensité de la première gamme de longueurs d'onde et NA étant l'ouverture numérique côté image de l'objectif de projection et/ou de sorte qu'une épaisseur de couche de la deuxième couche de résine photosensible (FLS2) soit dans la gamme allant de $RU_2$ à $RU_2/4$, avec $RU_2 = \lambda_2/NA^2$, $\lambda_2$ étant une longueur d'onde d'intensité de la deuxième gamme de longueurs d'onde et NA soit l'ouverture numérique côté image de l'objectif de projection.

7. Procédé d'éclairement par projection selon l'une des revendications précédentes, le revêtement étant réalisé de sorte que l'épaisseur de couche de la première couche de résine photosensible (FLS1) et/ou l'épaisseur de couche de la deuxième couche de résine photosensible (FLS2) soient dans la gamme allant de 50 nm à 1500 nm, en particulier dans la gamme allant de 100 nm à 1000 nm.

8. Procédé d'éclairement par projection selon l'une des revendications précédentes, une distance spectrale $\Delta\lambda$ entre les longueurs d'onde d'intensité de la première gamme de longueurs d'onde et de la deuxième gamme de longueurs d'onde étant d'au moins 10 nm et/ou une lampe à vapeur de mercure étant utilisée comme source de rayonnement (RS), la première gamme de longueurs d'onde contenant exactement une des raies de mercure d'une longueur d'onde d'intensité à environ 365 nm (raie i), environ 405 nm (raie h) et environ 436 nm (raie g) et la deuxième gamme de longueur d'onde contenant exactement une autre des raies de mercure.

9. Installation d'éclairement par projection destinée à éclairer un substrat, disposé au niveau d'un plan image d'un objectif de projection, avec au moins une image d'un motif d'un masque disposé au niveau d'un plan objet de l'objectif de projection, ledit système comprenant :

   une source de rayonnement primaire (RS) destinée à délivrer un rayonnement dans une gamme de longueurs d'onde de travail qui comprend une première gamme de longueurs d'onde et une deuxième gamme de longueurs d'onde distincte de la première gamme de longueurs d'onde ;
   un système d'éclairement (ILL) destiné à recevoir le rayonnement et à générer un rayonnement d'éclairement dirigé sur le masque (M) ;
   un objectif de projection (PO) destiné à générer une image du motif au niveau de la surface d'image (IS) de l'objectif de projection, l'objectif de projection étant corrigé au moins pour la première gamme de longueurs d'onde et la deuxième gamme de longueurs d'onde de sorte qu'une reproduction nette, à diffraction limitée, du motif sur le substrat soit possible avec chaque longueur d'onde des première et
   deuxième gammes de longueurs d'onde avec une échelle de reproduction identique,
   **caractérisée en ce que**
   une distance spectrale $\Delta\lambda$ entre les longueurs d'onde d'intensité de la première gamme de longueurs d'onde et de la deuxième gamme de longueurs d'onde est d'au moins 10 nm et une première gamme de focales (FOC1), appartenant à la première gamme de longueurs d'onde, est décalée d'une distance focale ($\Delta$FOC) par rapport à une deuxième gamme de focales (FOC2) appartenant à la deuxième gamme de longueur d'onde.

10. Système d'éclairement par projection selon la revendication 9, l'objectif de projection (PO) étant conçu de sorte que la distance de focale ($\Delta$FOC) soit située dans la gamme allant de $RU_M$ à $RU_M/4$, avec $RU_M = \lambda_M/NA^2$, $\lambda_M$ étant une longueur d'onde de travail moyennée à partir de la première et de la deuxième gamme de longueurs d'onde et NA étant l'ouverture numérique côté image de l'objectif de projection.

11. Installation d'éclairement par projection selon la revendication 9 ou 10, la source de rayonnement (RS) comportant une lampe à vapeur de mercure, la première gamme de longueurs d'onde contenant exactement une des raies de mercure d'une longueur d'onde d'intensité à environ 365 nm (raie i), environ 405 nm (raie h) et environ 436 nm (raie g) et la deuxième gamme de longueur d'onde contenant exactement une autre des raies de mercure.

Fig. 1

Fig. 2

Fig. 3

λ1    λ2

MS {

FLS1

FLS2

SUB

Fig. 4

λ1    λ2

MS {

FLS1

FFS

FLS2

SUB

Fig. 5

Fig. 6A

Fig. 6B

OS

IS

700

## Fig. 7

OS

DB

IS

800

## Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20120049262 A1
- US 8445447 B2
- US 2010272967 A1
- US 4937619 A
- US 7760452 B2

**In der Beschreibung aufgeführte Nicht-Patentliteratur**

- **B. TODD ; W.W. FLACK ; S. WHITE.** Thick Photoresist Imaging Using A Three Wavelength Exposure Stepper. *SPIE MEMS 1999 #3874 -40,* 1-15
- **J. PAUL ; M. RUDOLPH ; S. RIEDEL ; X. THRUN ; S. WEGE ; C. HOHLE.** Evaluation of an advanced dual hard mask stack for high resolution pattern transfer. *Proc. of SPIE,* vol. 8685, 86850V-1, 86850V-11